# EUROPEAN PATENT APPLICATION

(11) **EP 4 276 913 A1**
(43) Date of publication of application: **15.11.2023**
(21) Application number: 23171020.3
(22) Date of filing: 02.05.2023
(51) Int. Cl.: H01L 29/423, H01L 21/336, H01L 29/775, H01L 29/06, H01L 29/10, H01L 29/78, H01L 27/088, H01L 27/12, H01L 21/8234, H01L 29/66, H01L 29/08, B82Y 10/00, H01L 29/161, H01L 29/417, H01L 29/165, H01L 21/762

(54) **SEMICONDUCTOR DEVICE AND METHOD OF MANUFACTURING THE SAME**

(30) Priority: 11.05.2022 KR 20220057662
(71) Applicant: Samsung Electronics Co., Ltd., Suwon-si, Gyeonggi-do 16677 (KR)
(72) Inventor: KIM, Sungmin, 16677 Suwon-si (KR)
(74) Representative: Marks & Clerk LLP

(57) **Abstract**

A semiconductor device includes an active fin extending in a first direction on an upper surface of a substrate, the active fin comprising a first fin portion and a second fin portion on the first fin portion; an isolation pattern between the first fin portion and the second fin portion; a gate structure intersecting the active fin and extending in a second direction intersecting the first direction; and source/drain regions in regions of the second fin portion on both sides of the gate structure, respectively; wherein the gate structure includes a gate electrode intersecting a region of the active fin and extending in the second direction, a pair of gate spacers extending in the second direction along both side surfaces of the gate electrode in the first direction and including the same material as a material of the isolation pattern, and a gate insulating layer between the gate electrode and the active fin.

## Description

### BACKGROUND

Example embodiments of the present disclosure relate to a semiconductor device and a method of manufacturing the same.

As demands for high performance, high speed, and/or multifunctionality of a semiconductor device have increased, demand for integration density of semiconductor devices has also increased. The development of a semiconductor device including a channel having a three-dimensional structure has been actively conducted to meet demand for high integration density of a semiconductor device.

### SUMMARY

An example embodiment of the present disclosure may provide a semiconductor device having improved reliability.

An example embodiment of the present disclosure may provide a method of manufacturing a semiconductor device having improved reliability through a simplified process.

According to an example embodiment of the present disclosure, a semiconductor device includes an active fin extending in a first direction on an upper surface of a substrate, the active fin comprising a first fin portion and a second fin portion on the first fin portion; an isolation pattern between the first fin portion and the second fin portion; a gate structure intersecting the active fin and extending in a second direction intersecting the first direction; and source/drain regions in regions of the second fin portion on both sides of the gate structure, respectively; wherein the gate structure includes a gate electrode intersecting a region of the active fin and extending in the second direction, a pair of gate spacers extending in the second direction along both side surfaces of the gate electrode in the first direction and including the same material as a material of the isolation pattern, and a gate insulating layer between the gate electrode and the active fin.

According to an example embodiment of the present disclosure, a semiconductor device includes a substrate having an upper surface including a first region and a second region; a first transistor on the first region of the substrate; and a second transistor on the second region of the substrate, wherein the first transistor includes a first active fin extending in a first direction on the first region of the substrate, where the first active fin has a first fin portion and a second fin portion on the first fin portion, a first isolation pattern between the first fin portion and the second fin portion, a first gate structure intersecting the first active fin and extending in a second direction intersecting the first direction, the first gate structure including a pair of first gate spacers including the same material as a material of the first isolation pattern, and first source/drain regions in regions of the second fin portion on both sides of the first gate structure, respectively, and wherein the second transistor includes a second active fin extending in the first direction on the second region of the substrate, a second gate structure intersecting the second active fin and extending in the second direction, and second source/drain regions in regions of the second active fin on both sides of the second gate structure, respectively.

According to an example embodiment of the present disclosure, a semiconductor device includes an active fin disposed on a substrate and extending in a first direction, the active fin having a first fin portion and a second fin portion on the first fin portion; an isolation pattern between the first fin portion and the second fin portion; a gate structure intersecting the active fin and extending in a second direction intersecting the first direction; and source/drain regions in regions of the second fin portion on both sides of the gate structure, respectively; wherein the gate structure includes a gate electrode intersecting one region of the active fin, and including an extension electrode portion passing through the one region between the first and second fin portions to at least partially surround the second fin portion in the second direction; a pair of gate spacers extending in the second direction along both side surfaces of the gate electrode in the first direction and including the same material as a material of the isolation pattern; and a gate insulating film between the gate electrode and the active fin.

According to an example embodiment of the present disclosure, a semiconductor device includes an active pattern extending in a first direction on an upper surface of the substrate, where the active pattern is divided into a first portion and a second portion in a vertical direction perpendicular to the upper surface of the substrate; an isolation pattern between the first and second portions of the active pattern; a plurality of channel layers spaced apart from each other in the vertical direction on the active pattern; a gate structure extending in a second direction intersecting the first direction to at least partially surround each of the plurality of channel layers; and source/drain regions disposed on regions of the second portion on both sides of the gate structure and connected to the plurality of channel layers, respectively, wherein the gate structure includes a gate electrode extending in the second direction to surround each of the plurality of channel layers, a pair of gate spacers extending in the second direction along both side surfaces of the gate electrode taken in the first direction and including the same material as a material of the isolation pattern, and a gate insulating layer between the gate electrode and the plurality of channel layers.

According to an example embodiment of the present disclosure, a method of manufacturing a semiconductor device includes providing a semiconductor substrate having an upper surface divided into a first region and a second region; forming a sacrificial pattern in the first region of the semiconductor substrate; growing a semiconductor layer on the semiconductor substrate to at least partially cover the sacrificial pattern; forming a first active fin and a second active fin extending in a first direction on the first and second regions of the semiconductor substrate by etching to a portion of regions of the semiconductor layer and the semiconductor substrate, where the first active fin has a first fin portion and a second fin portion on the first fin portion, and the first fin portion and the second fin portion are isolated from each other by the sacrificial pattern; forming a first dummy gate structure and a second dummy gate structure that intersect the first active fin and the second active fin, respectively; removing the sacrificial pattern from the first active fin to form an isolation space between the first fin portion and the second fin portion; forming a pair of first gate spacers and a pair of second gate spacers on both side surfaces of the first dummy gate structure and the second dummy gate structure, respectively, and forming an isolation pattern by filling the isolation space with the same material as a material of the first and second gate spacers; forming a first source/drain region and a second source/drain region in regions of the first active fin on both sides of the first dummy gate structure and regions of the second active fin on both sides of the second dummy gate structure, respectively; removing the first dummy gate structure and the second dummy gate structure to form a first gate space and a second gate space; and forming a first gate structure and a second gate structure in the first gate space and the second gate space, respectively.

At least some of the above and other features of the invention are set out in the claims.

### BRIEF DESCRIPTION OF DRAWINGS

The above and other aspects, features, and advantages of the present disclosure will be more clearly understood from the following detailed description, taken in combination with the accompanying drawings, in which:
FIGS. 1A and 1B are plan diagrams illustrating a first region and a second region of a semiconductor device according to an example embodiment of the present disclosure;
FIGS. 2A and 2B are cross-sectional diagrams illustrating the semiconductor device embodiment illustrated in FIGS. 1A and 1B taken along lines Ia-Ia' and Ib-Ib', respectively;
FIGS. 3A and 3B are cross-sectional diagrams illustrating the semiconductor device embodiment illustrated in FIGS. 1A and 1B taken along lines II1a-II1a' and IIb-IIb', respectively;
FIGS. 4A and 4B are cross-sectional diagrams illustrating the semiconductor device embodiment illustrated in FIGS. 1A and 1B taken along lines II2a-II2a' and II2b-II2b', respectively;
FIGS. 5A and 5B are cross-sectional diagrams illustrating a semiconductor device according to an example embodiment of the present disclosure;
FIG. 6 is a plan diagram illustrating a semiconductor device according to an example embodiment of the present disclosure;
FIGS. 7A to 7C are cross-sectional diagrams illustrating the semiconductor device embodiment illustrated in FIG. 6 taken along lines I-I', II1-II1', and II2-II2', respectively;
FIG. 8 is a cross-sectional diagram illustrating a semiconductor device according to an example embodiment of the present disclosure;
FIG. 9 is a plan diagram illustrating a semiconductor device according to an example embodiment of the present disclosure;
FIGS. 10A to 10C are cross-sectional diagrams illustrating the semiconductor device embodiment illustrated in FIG. 9 taken along lines I-I', II1-II1', and II2-II2', respectively;
FIGS. 11A to 11D are cross-sectional diagrams illustrating operations of a method of manufacturing a semiconductor device (operations of manufacturing a substrate) according to an example embodiment of the present disclosure;
FIGS. 12A to 12F are cross-sectional diagrams illustrating operations of a method of manufacturing a semiconductor device (a fin isolation process) according to an example embodiment of the present disclosure;
FIGS. 13A to 13D are cross-sectional diagrams illustrating operations of a method of manufacturing a semiconductor device (operations of forming a gate structure) according to an example embodiment of the present disclosure;
FIGS. 14A to 14F are plan diagrams illustrating the semiconductor device embodiments illustrated in FIGS. 11A, 11C, 12A, 12C, 12F, and 13B, respectively;
FIGS. 15A to 15F are cross-sectional diagrams illustrating operations of a method of manufacturing a semiconductor device according to an example embodiment of the present disclosure;
FIG. 16 is a plan diagram illustrating a semiconductor device according to an example embodiment of the present disclosure;
FIG. 17A to 17C are cross-sectional diagrams illustrating the semiconductor device embodiments illustrated in FIG. 16 taken along lines I-I', II1-II1', and II2-II2', respectively;
FIG. 18 is a plan diagram illustrating a semiconductor device according to an example embodiment of the present disclosure;
FIGS. 19A to 19C are cross-sectional diagrams illustrating the semiconductor device embodiment illustrated in FIG. 18 taken along lines I-I', II1-II1', and II2-II2', respectively; and
FIGS. 20A to 20H are cross-sectional diagrams illustrating processes of a method of manufacturing a semiconductor device according to an example embodiment of the present disclosure.

### DETAILED DESCRIPTION

Hereinafter, embodiments of the present disclosure will be described as follows with reference to the accompanying drawings. The present inventive subject matter may, however, be embodied in many different forms and should not be construed as limited to the embodiments set forth herein. In the drawings, like numerals refer to like elements throughout the description and repeated descriptions may be omitted. It will be understood that, although the terms first, second, etc. may be used herein to describe various elements, these elements should not be limited by these terms. These terms are only used to distinguish one element from another element. Thus, for example, a first element, a first component or a first section discussed below could be termed a second element, a second component or a second section without departing from the teachings of the present inventive concept. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

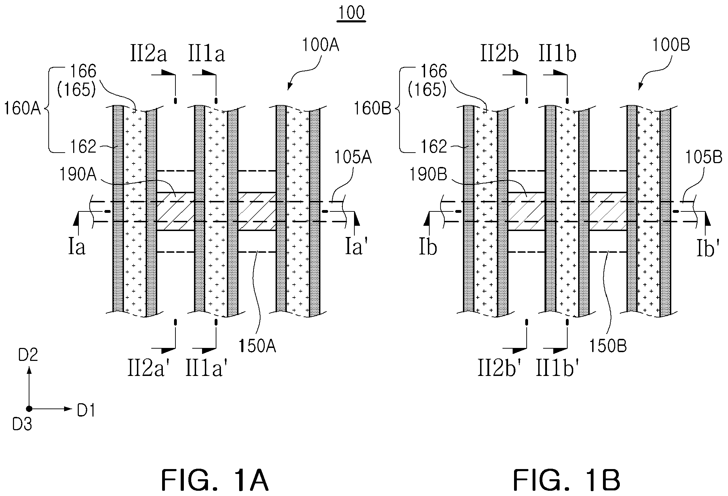

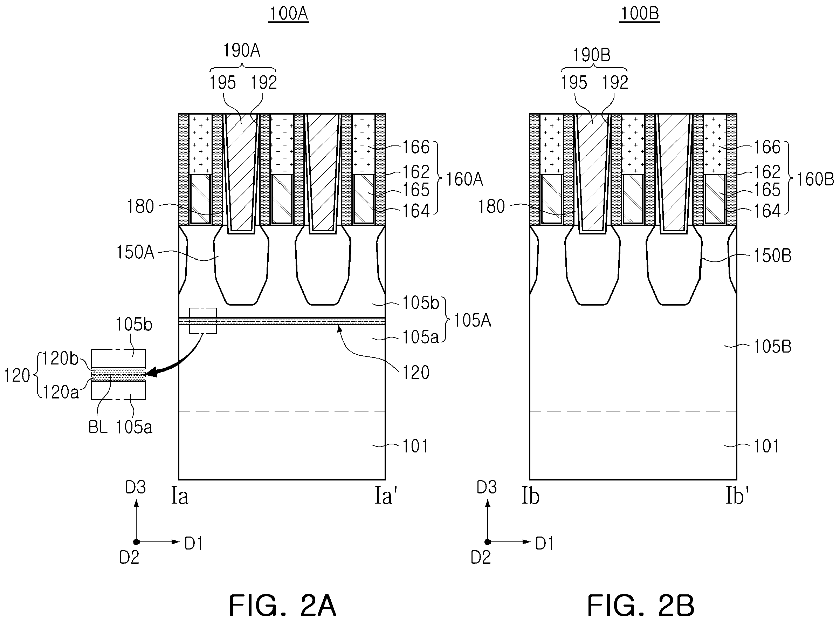

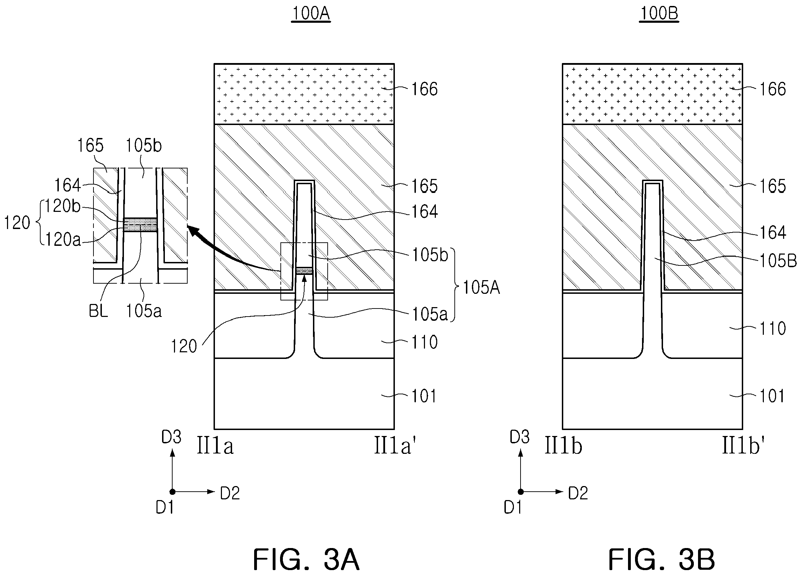

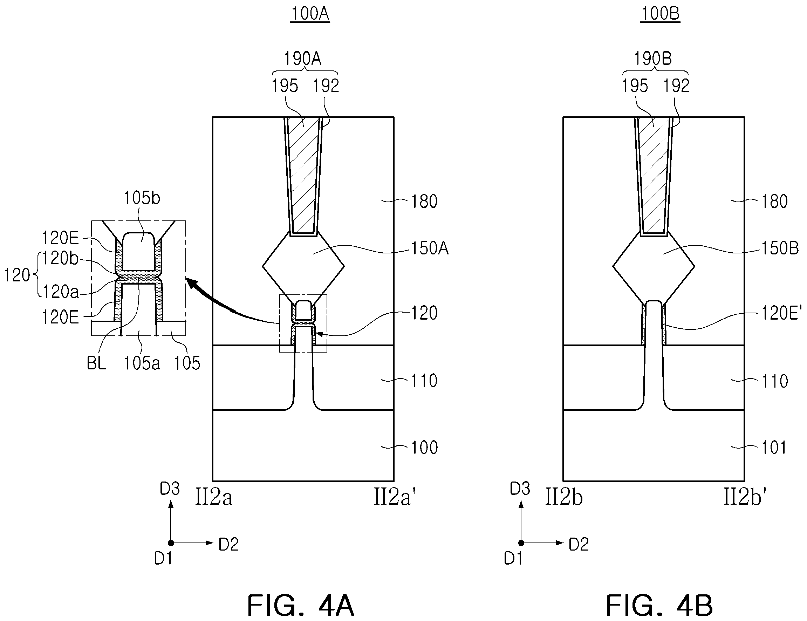

FIGS. 1A and 1B are plan diagrams illustrating a first region and a second region of a semiconductor device according to an example embodiment. FIGS. 2A and 2B are cross-sectional diagrams illustrating the semiconductor device embodiments illustrated in FIGS. 1A and 1B taken along lines Ia-Ia' and Ib-Ib', respectively. FIGS. 3A and 3B are cross-sectional diagrams illustrating the semiconductor device embodiments illustrated in FIGS. 1A and 1B taken along lines II1a-II1a' and IIb-IIb', respectively. FIGS. 4A and 4B are cross-sectional diagrams illustrating the semiconductor device embodiments illustrated in FIGS. 1A and 1B taken along lines II2a-II2a' and II2b-II2b', respectively.

Referring to FIGS. 1A to 4B, a semiconductor device 100 according to the example embodiment may include a substrate 101, a first transistor 100A and a second transistor 100B in different regions of the substrate 101. FIGS. 1A, 2A, 3A, and 4A illustrate the first transistor 100A, and FIGS. 1B, 2B, 3B and 4B illustrate the second transistor 100B.

Referring to FIG. 1A, the first transistor 100A may include a first active fin 105A extending in a first direction (e.g., D1) in a first region of a substrate 101, and a plurality of first gate structures 160A intersecting the first active fin 105A and extending in a second direction (e.g., D2) perpendicular to the first direction. Similarly, referring to FIG. 1B, the second transistor 100B may include a second active fin 105B extending in a first direction (e.g., D1) in a second region of the substrate 101 and a plurality of second gate structures 160B intersecting the active fin 105A and extending in a second direction (e.g., D2) perpendicular to the first direction.

The substrate 101 may include, for example, a semiconductor, such as Si or Ge, or a compound semiconductor, such as SiGe, SiC, GaAs, InAs or InP. The substrate 101 may include an active region, such as a well doped with impurities or a structure doped with impurities. For example, the active region of the first region may have a p-type well for an N-MOSFET, and the active region of the second region may have an n-type well for a P-MOSFET.

In example embodiments, the first transistor 100A may include a single gate (SG) transistor, and the second transistor 100B may include an enhanced gate (EG) transistor. In example embodiments, the first transistor 100A may include an n-channel metal-oxide-semiconductor field-effect transistor (N-MOSFET) and the second transistor 100B may include a p-channel metal-oxide-semiconductor field-effect transistor (P-MOSFET), but an example embodiment thereof is not limited thereto.

Hereinafter, the structures of the first and second transistors 100A and 100B implemented on one substrate 101 will be described in greater detail with reference to FIGS. 2A to 4B together with FIGS. 1A and 1B.

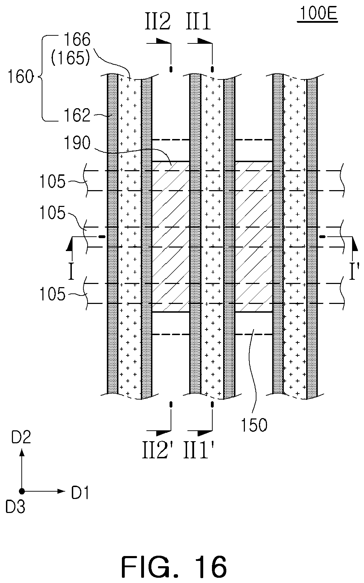

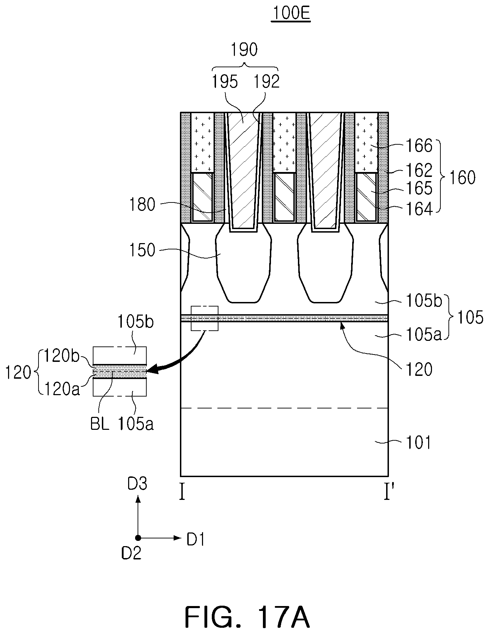

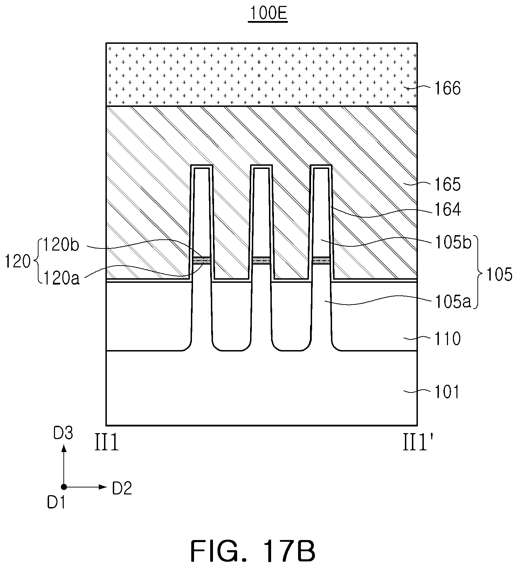

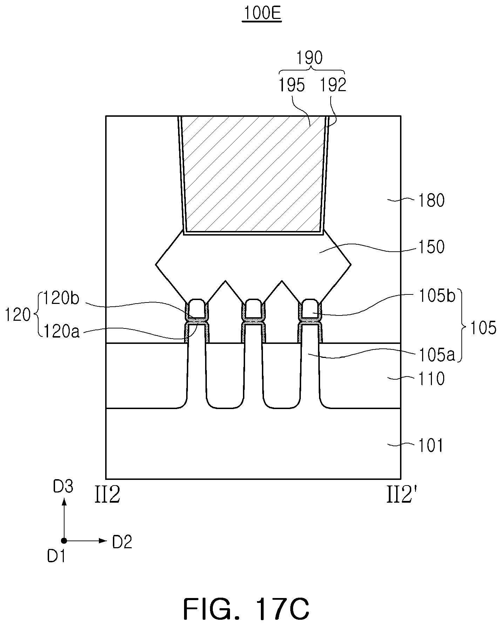

The first and second active fins 105A and 105B may have a pattern protruding from the upper surface of the substrate 101 (or active region) in a third direction (e.g., D3). The third direction (e.g. D3) may be perpendicular to the upper surface of the substrate 101. The third direction (e.g. D3) may be perpendicular to the first direction (e.g. D1) and the second direction (e.g. D2). The first and second active fins 105A and 105B may work as a channel region of each of the transistors 100A and 100B. In the example embodiment, the number of each of the first and second active fins 105A and 105A is one in the drawings, but a plurality of the first and second active fins 105A and 105A may be provided side by side in the second direction (e.g., D1) (see FIGS. 16 and 17A to FIG. 17c).

The device isolation layer 110 may define first and second active fins 105A and 105B (see FIGS. 3A and 3B and 4A and 4B). The device isolation layer 110 may be a shallow trench isolation layer. For example, the device isolation layer 110 may include silicon oxide or a silicon oxide-based insulating material. The first and second active fins 105A and 105B may extend through the device isolation layer 110, and a portion thereof may protrude from an upper portion of the device isolation layer 110.

The first and second transistors 100A and 100B may include first and second gate structures 160A and 160B, respectively. As illustrated in FIG. 1, the first and second gate structures 160A and 160B may have a line shape extending in the second direction (e.g., D2) in the first and second regions, respectively. The first and second gate structures 160A and 160B may overlap one region of each of the first and second active fins 105A and 105B in the D3 direction. Each of the first and second gate structures 160A and 160B may include a pair of gate spacers 162, a gate insulating layer 164 and a gate disposed in order between the pair of gate spacers 162, and a gate capping layer 166 disposed on the gate electrode 165. That is, the gate electrode 165 may intersect one region of each of the first and second active fins 105A and 105B as shown in FIGS. 1A and 1B, and may extend in a second direction (e.g., D2), and the pair of gate spacers 162 may be disposed on both side surfaces of each of the gate electrodes 165 in the first direction (e.g., D1).

For example, the gate insulating layer 164 may include silicon oxide and/or a high-k dielectric. The gate electrode 165 may include a conductive material, such as doped silicon, a metal nitride (e.g., TiN, TaN, or WN, etc.), or a metal (e.g., W, etc.). For example, the gate spacer 162 may be formed of an insulating material, such as SiO, SiN, SiON, or SiOC, and the gate capping layer 166 may be formed of an insulating material, such as SiN or SiON.

In example embodiments, components of the first gate structure 160A and the second gate structure 160B may be configured differently. For example, when the first transistor 100A is an SG transistor and the second transistor 100B is an EG transistor, the gate insulating layer 164 of the second gate structure 160B may have a thickness greater than a thickness of the gate insulating layer 164 of the first gate structure 160A.

In the example embodiment, the first transistor 100A may have an isolation pattern 120, which is an insulating film embedded in the first active fin 105A similar to the SOI fin field-effect transistor (FinFET) structure to prevent or mitigate a short channel effect.

The first active fin 105A used in the example embodiment may include a first fin portion 105a and a second fin portion 105b in a third direction (e.g., D3) perpendicular to the upper surface of the substrate 101, and the isolation pattern 120 may be disposed between the first fin portion 105a and the second fin portion 105b. The isolation pattern 120 may be formed together with the gate spacer 162 of the first gate structure 160A.

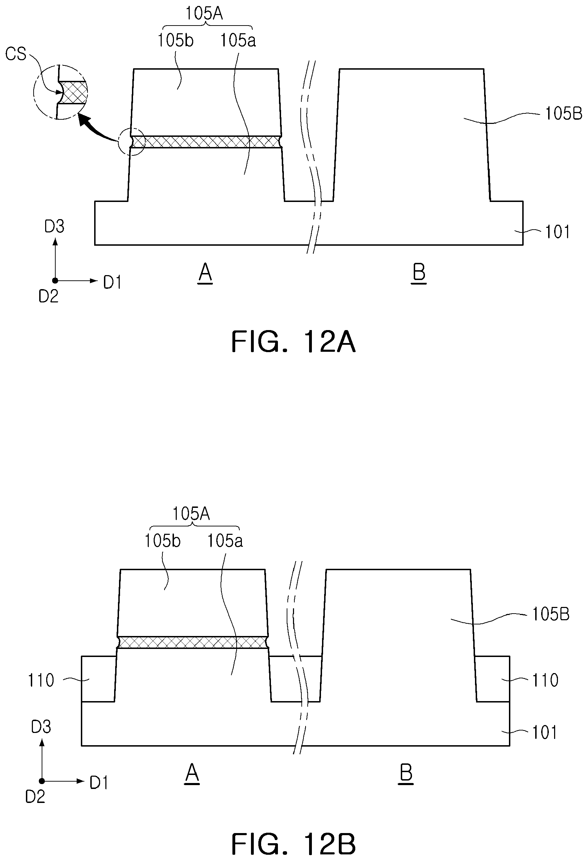

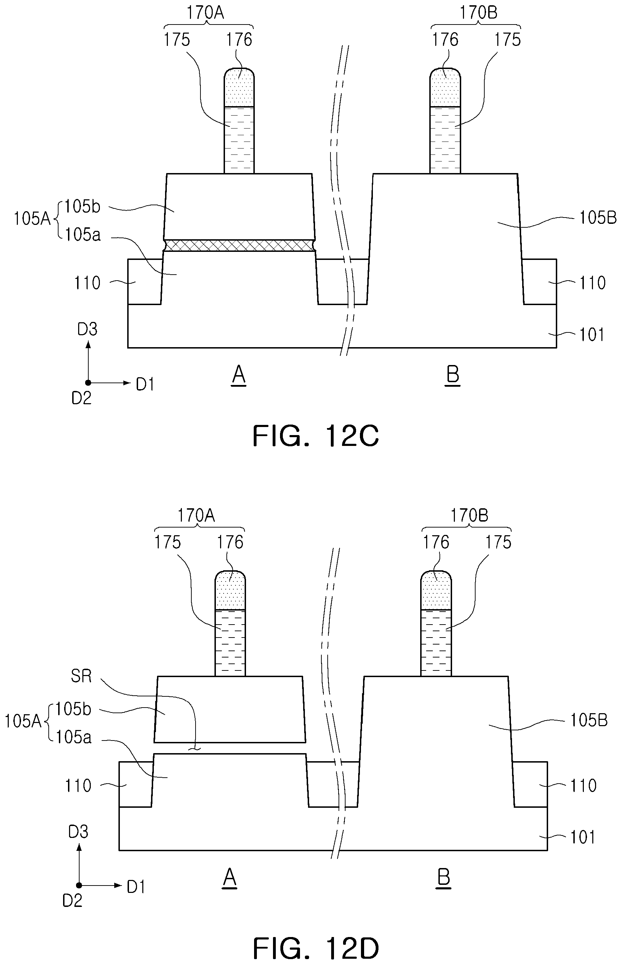

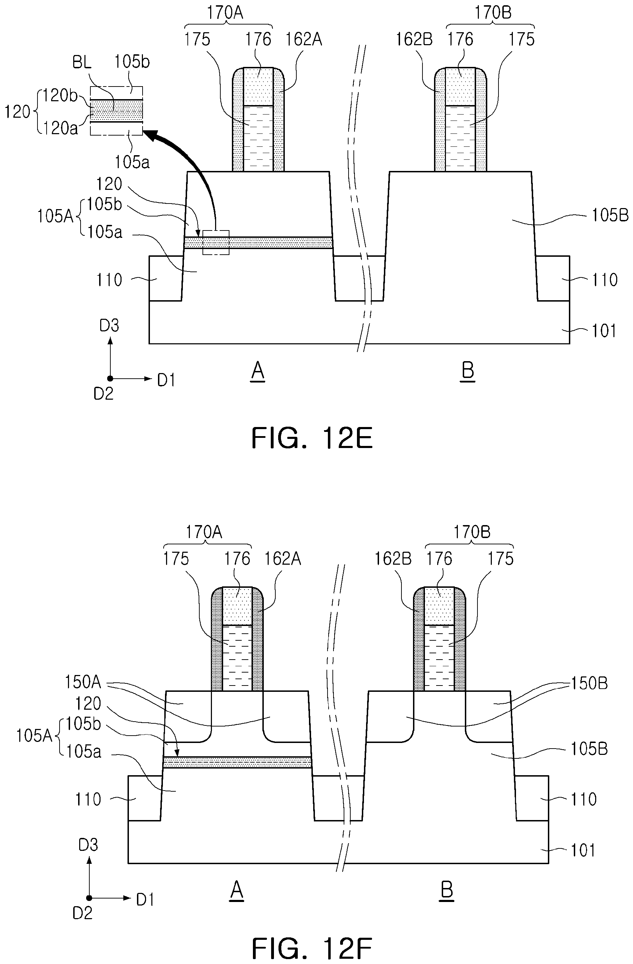

For example, the isolation pattern 120 used in the example embodiment may be provided using a sacrificial pattern 131 (in FIG. 12A) embedded in the first region of the substrate 101 in advance, rather than using a silicon on insulator (SOI) substrate manufactured as the substrate 101 in advance. Specifically, the first active fin 105A may be formed, the sacrificial pattern may be removed, and the vacant space may be at least partially filled with the same insulating material as an insulating material of the gate spacer 162 in the process of forming the gate spacer 162, thereby forming the isolation pattern 120 (see FIGS. 12D and 12E). During this filling process, the isolation pattern 120 may be grown from the upper surface of the first fin portion 105a and the lower surface of the second fin portion 105b, and the growth from the two different fin portions 105a and 105b may be merged with each other.

As illustrated in FIGS. 2A, 3A and 4A, the isolation pattern 120 used in the example embodiment may include a first portion 120a grown from the upper surface of the first fin portion 105a, and a second portion 120b grown from a lower surface of the second fin portion 105b, and the first portion 120a and the second portion 120b may have a boundary surface BL therebetween. The boundary surface BL may be formed by merging the first portion 120a with the second portion 120b, and may be visually identified in an image taken by an electron microscopy (e.g., SEM, TEM).

However, on the cross-section in FIG. 2A, because the process of forming the isolation pattern 120 is slightly different from the other regions, the boundary surface BL may appear differently or may not be distinct. Specifically, when the isolation pattern 120 is formed, the isolation pattern 120 may be formed in a space at least partially surrounded by the dummy gate structure on the cross-section illustrated in FIG. 2A, such that an insulating material may be grown from the upper surface of the first fin portion 105a and the lower surface of the second fin portion 105b, and also the surface (the side surface of the space) provided by the dummy gate structure, and may at least partially fill the region. Accordingly, the boundary surface BL may not appear differently from the other regions (e.g., FIG. 4A) or may not be distinct.

In a cross-section in the second direction (e.g., D2) of a portion of the first active fin 105A in which the first source/drain regions 150A are disposed (see FIG. 4A), the isolation pattern 120 may have a sidewall extension portion 120E extending to sidewalls of the first active fin 150A, that is, the first fin portion 150a and the second fin portion 150b. Similarly, referring to FIG. 4B, a material film 120E' the same as the gate spacer 162 may be formed on each of both sidewalls of the second active fin 105A in the second direction (e.g., D2) below the first source/drain regions 150A.

In the example embodiment, the first transistor 100A may be implemented in a structure in which the isolation pattern 120 is provided in the first active fin 105A similar to a SOI finFET without using an SOI substrate, and the second transistor 100B may be implemented in a FinFET structure similarly to a bulk FinFET.

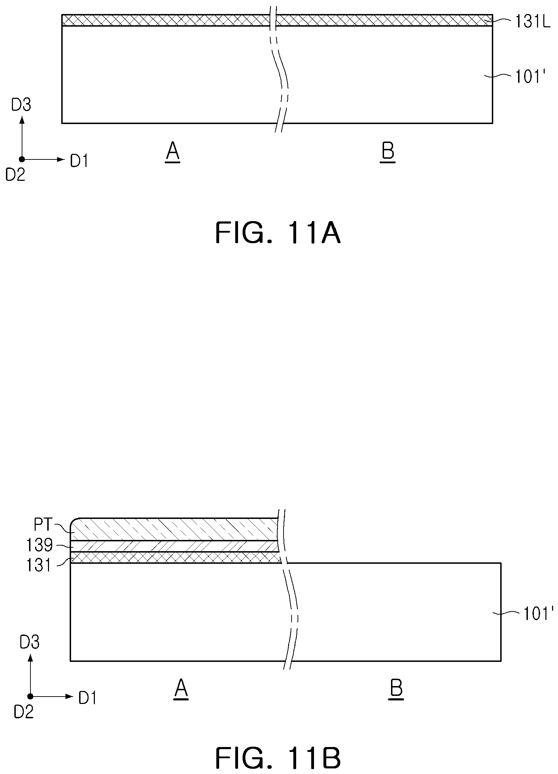

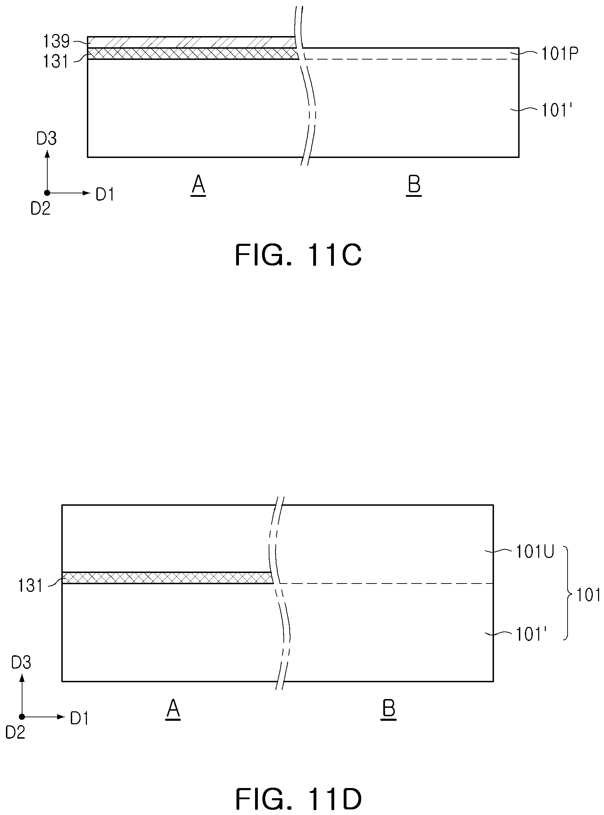

As such, in the example embodiment, a sacrificial pattern for the isolation pattern 120 may be selectively provided only in the first region of the substrate 101 (see FIG. 11B). Despite the selective provision of the sacrificial pattern, the substrate 101 may have a flat upper surface throughout the first region and the second region (see FIGS. 11C and 11D). Accordingly, the first and second active fins 105A and 105B may have substantially the same level in the D3 direction. As illustrated in FIGS. 3A and 3B, the upper end of the first active fin 105A covered by the first gate structure 160A may have the same level in the D3 direction as a level of the upper end of the second active fin 105B covered by the second gate structure 160A.

The first transistor 100A may include first source/drain regions 150A disposed in regions of the first active fin 105A disposed on both sides of the first gate structure 160A. Similarly, the second transistor 100B may include second source/drain regions 150B disposed in regions of the second active fin 105B disposed on both sides of the second gate structure 160B.

The first and second source/drain regions 150A and 150B may include Si, SiGe, or Ge, and, the first and second source/drain regions 150A and 150B may have different materials or different shapes based on the N or P-MOSFET implementation. For example, when the first transistor 100A is an N-MOSFET, the first source/drain regions 150A may include silicon, and may be doped with N-type impurities (e.g., phosphorus (P), nitrogen (N), arsenic (As), and antimony (Sb)). The first source/drain regions 150A may have a hexagonal cross-section or a polygonal cross-section having a gentle angle. When the first transistor 100B is a PMOS transistor, the second source/drain region 150B may include silicon-germanium (SiGe), and may be doped with P-type impurities (e.g., boron (B), indium (In), and gallium (Ga)). The second source/drain regions 150B may have a pentagonal cross-section.

As such, the first and second transistors 100A and 100B may include the first and second active fins 105A and 105B, the first and second gate structures 160A and 160B, and the second source/drain regions 150A and 150B, respectively.

An interlayer insulating layer 180 may be disposed on the device isolation layer 110. The interlayer insulating layer 180 may be disposed on the first and second source/drain regions 150A and 150B and may at least partially surround the first and second gate structures 160A and 160B. For example, the interlayer insulating layer 180 may include flowable oxide (FOX), tonen silazen (TOSZ), undoped silica glass (USG), borosilica glass (BSG), phosphosilaca glass (PSG), borophosphosilica glass (BPSG), plasma enhanced tetra ethyl ortho silicate (PETEOS), fluoride silicate glass (FSG), high density plasma (HDP) oxide, plasma enhanced oxide (PEOX), flowable CVD (FCVD) oxide, or a combination thereof. The interlayer insulating layer 180 may be formed using a chemical vapor deposition (CVD) process, a flowable-CVD process, or a spin coating process.

Referring to FIGS. 2A and 2B and 4A and 4B, the first and second transistors 100A and 100B may include first and second contact structures 190A and 190B connected to the first and second source/drain regions 150A and 150B, respectively. Each of the first and second contact structures 190A and 190B may extend through the interlayer insulating layer 180 in the third direction (e.g., D3). Each of the first and second contact structures 190A and 190B may include a contact plug 195 and a conductive barrier layer 192 at least partially surrounding sidewalls and lower surfaces of the contact plug 195. For example, the conductive barrier layer 192 may include Ti, Ta, TiN, TaN, or a combination thereof, and the contact plug 195 may include tungsten (W), cobalt (Co), titanium (Ti), or alloys thereof or a combination thereof. The first and second source/drain regions 150A and 150B may include a metal silicide layer for reducing contact resistance in regions in contact with the first and second contact structures 190A and 190B, respectively. For example, the metal silicide layer may include CoSi, NiSi, or TiSi.

As described above, the semiconductor device 100 according to the example embodiment may effectively prevent or mitigate a short channel effect in the first transistor 100A by providing the isolation pattern 120 formed of the same material as the material of the gate spacer 162 to the first active fin 105A, rather than using a relatively expensive SOI substrate as the substrate 101. Also, the first transistor 100A having the isolation pattern 120 similar to the SOI FinFET and the second transistor 100B similar to the bulk FinFET may be formed together on a single substrate 101.

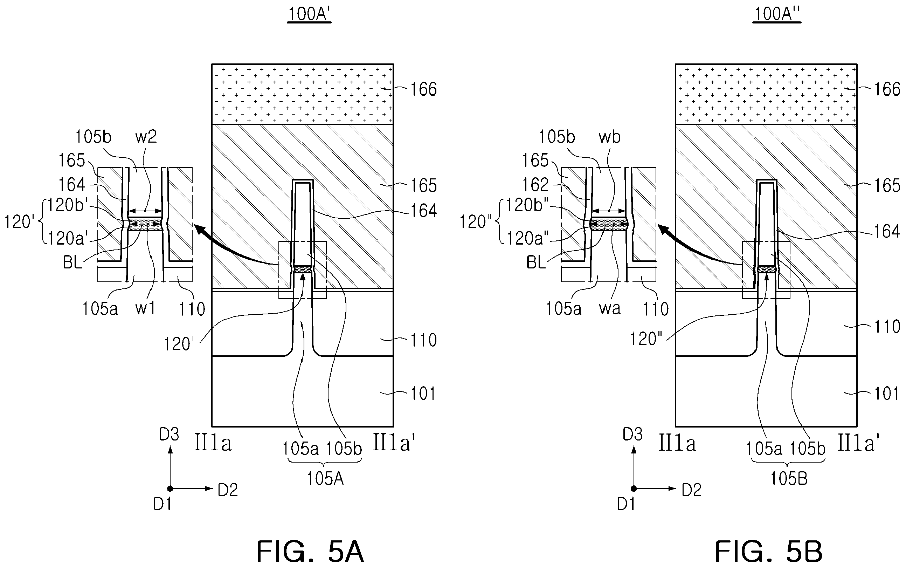

FIGS. 5A and 5B are cross-sectional diagrams illustrating a semiconductor device according to an example embodiment.

The cross-sections illustrated in FIGS. 5A and 5B may correspond to the cross-section in FIG. 3A, and may be the cross-sections of the portion of each of the active fins 150 in which the gate structure 160 (or the gate electrode 165) is disposed, taken in the second direction (e.g., D2).

Referring to FIGS. 5A and 5B, semiconductor devices 100A' and 100A" according to an example embodiment may include isolation patterns 120' and 120" disposed in the active fins 105, that is, between a first fin portion 105a and a second fin portion 105b.

The isolation patterns 120' and 120" may each include a first portion 120a' and 120a" grown from the upper surface of the first fin portion 105a, and a second portion 120b' and 120b" grown from a lower surface of the second fin portion 105b similar to the aforementioned example embodiment, and the first portion 120a' and 120a" and second portion 120b' and 120b" may have a boundary surface BL therebetween. The isolation patterns 120' and 120" may have a width different from the width of the active fins 150.

Referring to FIG. 5A, the isolation pattern 120' may have a width W1 smaller than a width W2 of adjacent portions of the first and second fin portions 105a and 105b.

Alternatively, referring to FIG. 5B, the isolation pattern 120" may have a width Wa greater than a width Wb of adjacent portions of the first and second fin portions 105a and 105b.

The width of the isolation patterns 120' and 120" may be determined based on an etching process condition for forming the active fin 105, and etching selectivity of the material forming the substrate 101 and the material of the sacrificial pattern 131 (in FIG. 11B). Specifically, when the sacrificial pattern is over-etched during the process of forming the active fin 105, as illustrated in FIG. 5A, the width W1 of the isolation pattern 120' may be relatively decreased, or alternatively, as illustrated in FIG. 5B, the width Wa of the isolation pattern 120" may be relatively increased.

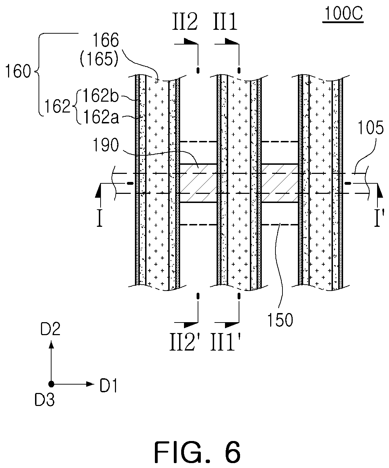

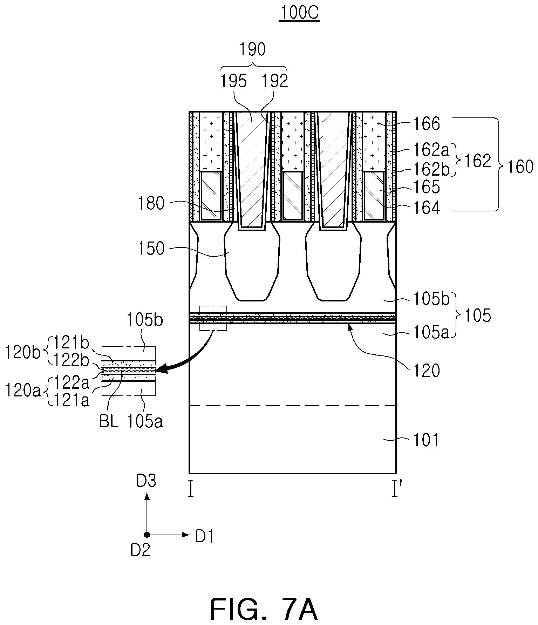

FIG. 6 is a plan diagram illustrating a semiconductor device according to an example embodiment. FIGS. 7A to 7C are cross-sectional diagrams illustrating the semiconductor device embodiment illustrated in FIG. 6 taken along lines I-I', II1-II1', and II2-II2', respectively.

Referring to FIGS. 6 and 7A to 7C, the semiconductor device 100C according to the example embodiment may be similar to the example embodiment illustrated in FIGS. 1A to 4B other than the configuration in which the gate spacer 162 includes a plurality of spacer films 162a and 162b, and a lamination structure of films included in the isolation pattern 120 is different. Also, the components in the example embodiment may be understood with reference to the descriptions of the same or similar components in the example embodiments illustrated in FIGS. 1A to 4B unless otherwise indicated.

Different from the aforementioned example embodiment, the gate spacer 162 employed in the example embodiment may include a plurality of spacer films 162a and 162b stacked in order on both side surfaces of the gate electrode 165.

As illustrated in FIGS. 6 and 7A, the gate spacer 162 may include a first spacer film 162a and a second spacer film 162b stacked in order on both sidewalls of the gate electrode 165. The first and second spacer films 162a and 162b may include insulating films having different dielectric constants. For example, at least one of the first and second spacer films 162a and 162b may include silicon oxide (SiOₓ), silicon nitride (SiNₓ), silicon oxynitride (SiOₓN_{y}), silicon carbonitride (SiCₓN_{y}), and/or silicon oxide carbonitride (SiOₓC_{y}N_{z}).

The isolation pattern 120 may have a first portion 120a and a second portion 120b having a boundary surface BL therebetween, and the first and second portions 120a and 120b may include first insulating films 121a and 121b and second insulating films 122a and 122b arranged symmetrically with respect to the boundary surface BL, respectively. That is, the first insulating film 121a, the second insulating film 122a, the second insulating film 122b, and the first insulating film 121b may be disposed or stacked in order from the upper surface of the first fin portion 105a in the D3 direction. The first insulating films 121a and 121b may include the same material as that of the first spacer film 162a, and the second insulating films 122a and 122b may include the same material as that of the second spacer film 162b.

As described above, according to the deposition order of the spacer films 162a and 162b of the gate spacer 162, the insulating films 121a and 121b and 122a and 122b formed of corresponding materials may be grown in order from the upper surface of the first fin portion 105a and the lower surface of the second fin portion 105b, respectively.

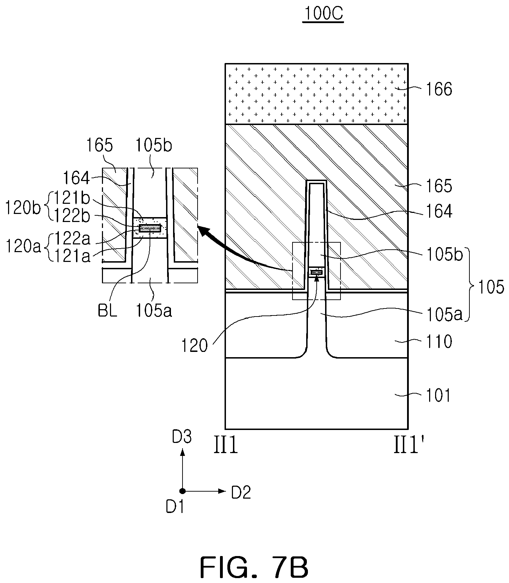

However, referring to FIG. 7B, the first insulating films 121a and 121b may be disposed to at least partially surround portions of the second insulating films 122a and 122b along the gate insulating layer 164. As described above, the process of forming the isolation pattern 120 may be slightly different from the examples in the other regions in the cross-section illustrated in FIG. 7B. Specifically, when the isolation pattern 120 is formed, both side surfaces of the cross-section illustrated in FIG. 7B may have a space at least partially surrounded by the dummy gate structure, such that the first insulating films 121a and 121b may be grown from the upper surface of the first fin portion 105a and the lower surface of the second fin portion 105b and also the side surfaces provided by the dummy gate structure. Accordingly, as illustrated in FIG. 7B, the first insulating films 121a and 121b may be at least partially surrounded, and the second insulating films 122a and 122b may at least partially fill the internal space thereof.

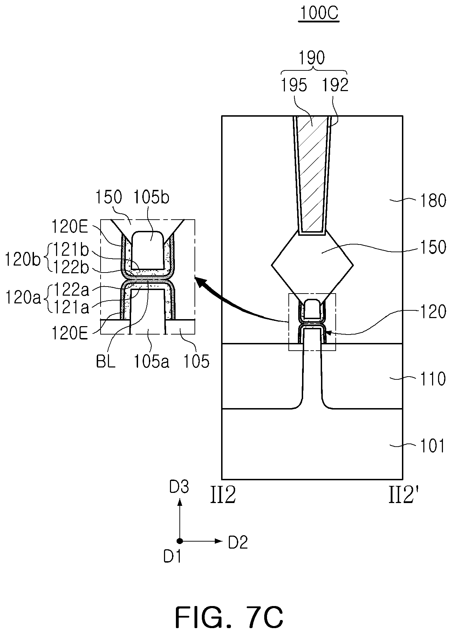

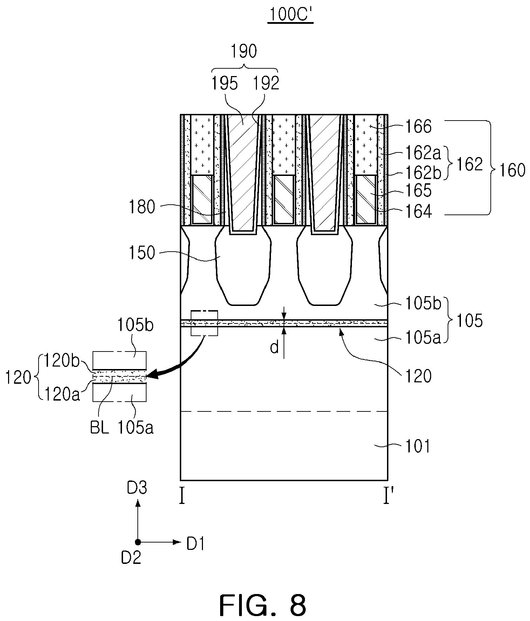

FIG. 8 is a cross-sectional diagram illustrating a semiconductor device according to an example embodiment. The cross-sections in FIG. 8 may correspond to the cross-sections in FIG. 7.

Referring to FIG. 8, a semiconductor device 100C' according to the example embodiment may have a double-filmed gate spacer 162, similar to the aforementioned example embodiment. Specifically, the gate spacer 162 used in the example embodiment may include first and second spacer films 162a and 162b stacked in order on both side surfaces of the gate electrode 165.

However, each of the first and second portions 120a and 120b of the isolation pattern 120 used in the example embodiment may include an insulating film formed of the same material as that of the first spacer film 162a. The insulating films of the first and second portions 120a and 120b may have a boundary surface BL therebetween.

In the example embodiment, when the gate spacer 162 is formed, the isolation pattern 120 may be formed only using an insulating film formed of the same material as that of the first spacer film 162a in the process of depositing the first spacer film 162a. For example, when the isolation pattern 120 is relatively thin, the isolation pattern 120 may be formed of only the same material as that of the spacer film 162a, which may be deposited preferentially, even though the isolation pattern 120 may include several spacer films 162a and 162b of the gate spacer 162.

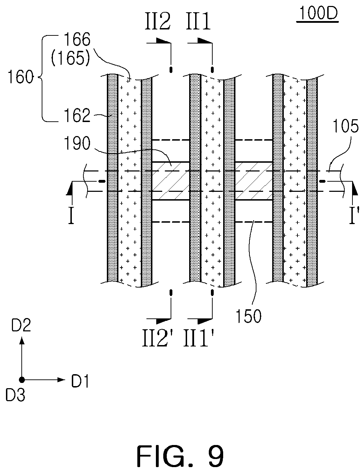

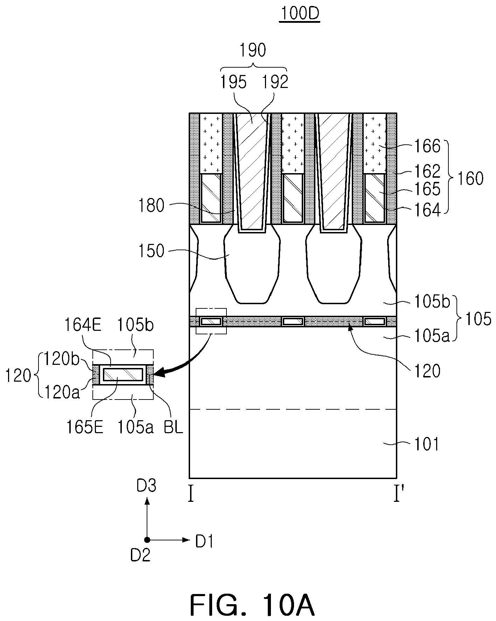

FIG. 9 is a plan diagram illustrating a semiconductor device according to an example embodiment. FIGS. 10A to 10C are cross-sectional diagrams illustrating the semiconductor device embodiment illustrated in FIG. 9 taken along lines I-I', II1-II1', and II2-II2', respectively.

Referring to FIGS. 9 and 10A to 10C, a semiconductor device 100D according to the example embodiment may be similar to the example embodiment illustrated in FIGS. 1A to 4B other than the configuration in which the gate structure 160, particularly, the gate electrode 165, has a gate-all-around (GAA) structure at least partially surrounding the second fin portion 105b in the second direction (e.g., D2). The components in the example embodiment may be understood with reference to the descriptions of the same or similar components in the example embodiments illustrated in FIGS. 1A to 4B unless otherwise indicated.

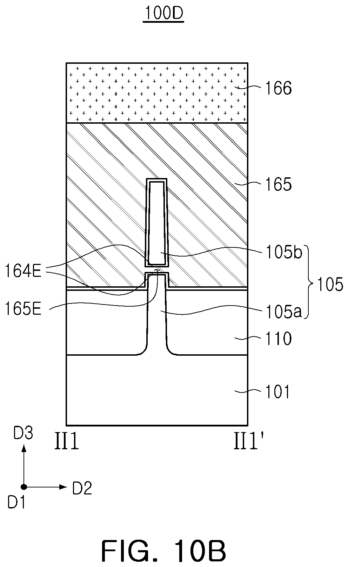

The gate electrode 165 used in the example embodiment may have an extension electrode portion 165E at least partially surrounding the second fin portion 105b in the second direction (e.g., D2) (see FIG. 10B). Also, the gate insulating layer 164 may have an extension portion 164E at least partially surrounding the extension electrode portion 165E in the first direction (e.g., D1) (see FIGS. 10A and 10B).

As illustrated in FIG. 10A, as the extension electrode portion 165E intersects one region (a portion overlapping the gate electrode) between the first fin portion 105a and the second fin portion 105, the isolation pattern 120 may be divided into a plurality of patterns in the first direction (e.g., D1) by the extension electrode portion 165E.

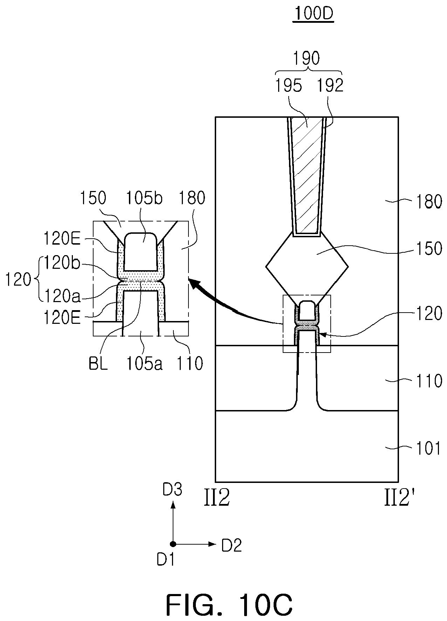

As illustrated in FIGS. 10A and 10C, in the semiconductor device 100D having a GAA structure according to the example embodiment, the isolation pattern 120 may be disposed in the portion of the active fin 105 other than a portion overlapping the gate electrode 165 in the third direction (e.g., D3), that is, a portion of the active fin 150 in which the source/drain regions 150 are disposed.

As such, the semiconductor device including the isolation pattern 120 in an example embodiment may be formed in various structures (e.g., FinFET, GAA-FET), and as in the example embodiment illustrated in FIG. 1, the semiconductor device may be implemented together with a bulk-FET, which does not have an isolation pattern on a substrate. For example, the semiconductor device 100D (GAA-FET) illustrated in FIGS. 9 and 10A to 10C may replace the first transistor 100A in FIG. 1A or may be formed in the same substrate 101 along with the first and second transistors 100A and 100B in FIG. 1.

Hereinafter, an example of a method of manufacturing a semiconductor device according to an example embodiment of the present inventive concept will be described. In the description of the manufacturing method (FIGS. 11A to 14F), an example in which an SOI FinFET and a bulk FinFET are formed on the same substrate, similar to the semiconductor device illustrated in FIGS. 1 to 4B, will be described.

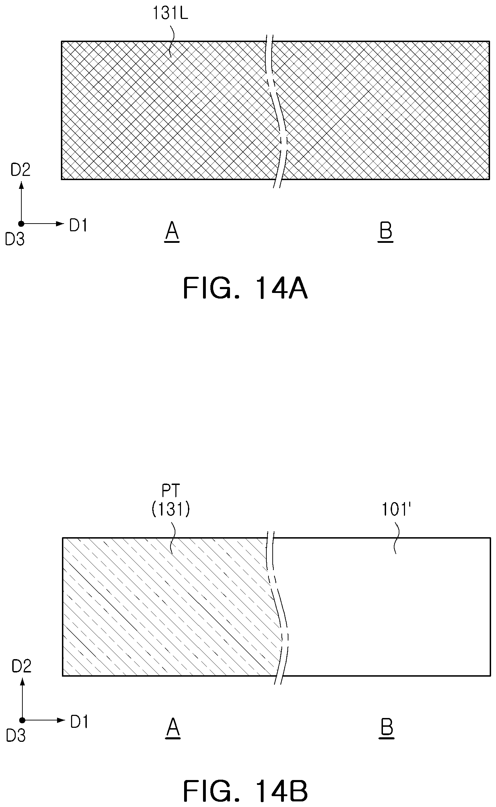

FIGS. 11A to 11D are cross-sectional diagrams illustrating operations of a method of manufacturing a semiconductor device (processes of manufacturing a substrate) according to an example embodiment. FIGS. 14A and 14B are plan diagrams illustrating the semiconductor device embodiments illustrated in FIGS. 11A and 11B, respectively.

Referring to FIGS. 11A and 14A, a sacrificial layer 131L may be formed on the semiconductor substrate 101'.

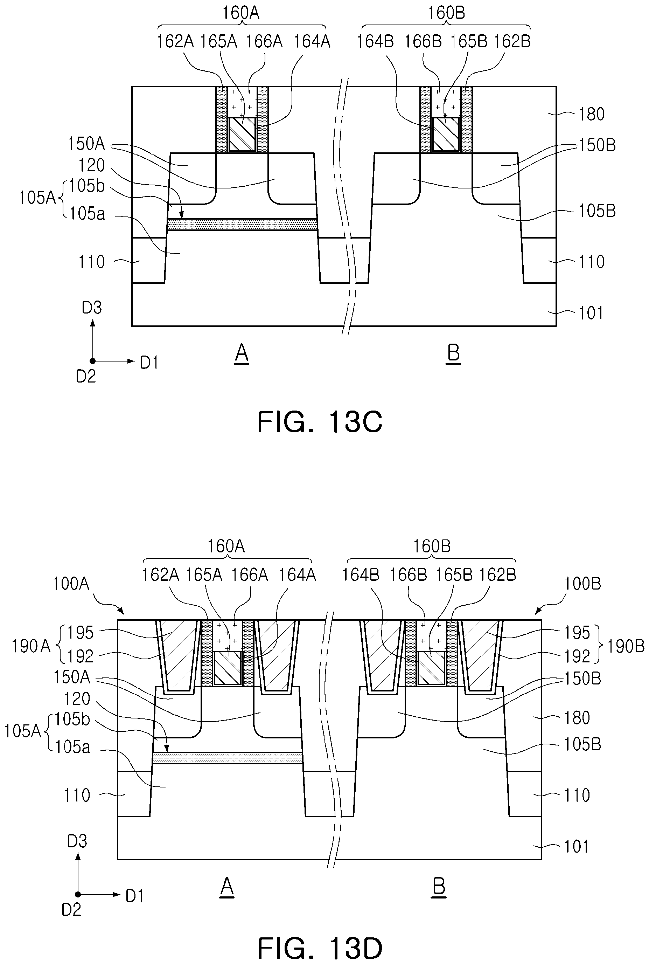

The semiconductor substrate 101' may be divided into a first region A and a second region B in which different types of devices are formed. The sacrificial layer 131L may include a semiconductor material having an etching selectivity with respect to the material of the semiconductor substrate 101'. For example, the semiconductor substrate 101' may be a silicon (Si) substrate, and the sacrificial layer 131L may include silicon-germanium (SiGe). The thickness of the sacrificial layer 131L may define the thickness of the isolation pattern 120 (in FIG. 13D) of the final structure.

Referring to FIG. 11B, a mask pattern 139 and a sacrificial pattern 131 at least partially covering the first region A of the semiconductor substrate 101' may be formed.

A mask material layer may be formed on the sacrificial layer 131L, and a mask material layer portion and a sacrificial layer portion disposed in the second region B may be selectively removed using the photoresist film PR, which opens the second region B. In the example embodiment, the mask material layer or the mask pattern 139 may be implemented as an amorphous material layer, which may suppress epitaxial growth. For example, the mask pattern 139 may include silicon oxide (SiOₓ), silicon nitride (SiNₓ), silicon oxynitride (SiOₓN_{y}), silicon carbonitride (SiCₓN_{y}), and/or silicon oxycarbonitride (SiOₓC_{y}N_{z}).

Referring to FIGS. 11C and 14B, the first semiconductor layer 101P may be grown in the second region B of the semiconductor substrate 101' using the mask pattern 139.

In this process, the first semiconductor layer 101P may be formed to have an upper surface having the same level as a level of the upper surface of the sacrificial pattern 131 in the D3 direction. The first semiconductor layer 101P may be formed of the same material as that of the semiconductor substrate 101'. For example, the first semiconductor layer 101P may include silicon. As such, the first semiconductor layer 101P may be provided as a planarization layer. Through this process, the final substrate 101 may have a generally flat upper surface without an additional planarization process.

Referring to FIG. 11D, a desired substrate 101 may be obtained by re-growing a second semiconductor layer 101U on the sacrificial pattern 131 and the first semiconductor layer 101P.

The substrate 101 may have the sacrificial pattern 131 embedded in the first region A, and may be formed in a single bulk (e.g., Si bulk) in the second region B. Although the substrate 101 manufactured according to the example embodiment has the sacrificial pattern 131 only in the first region A, the substrate 101 may have a generally flat upper surface without an additional planarization process.

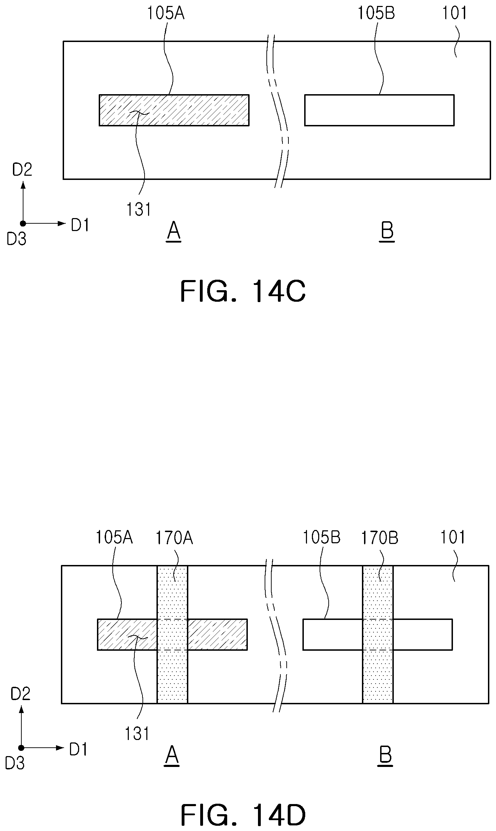

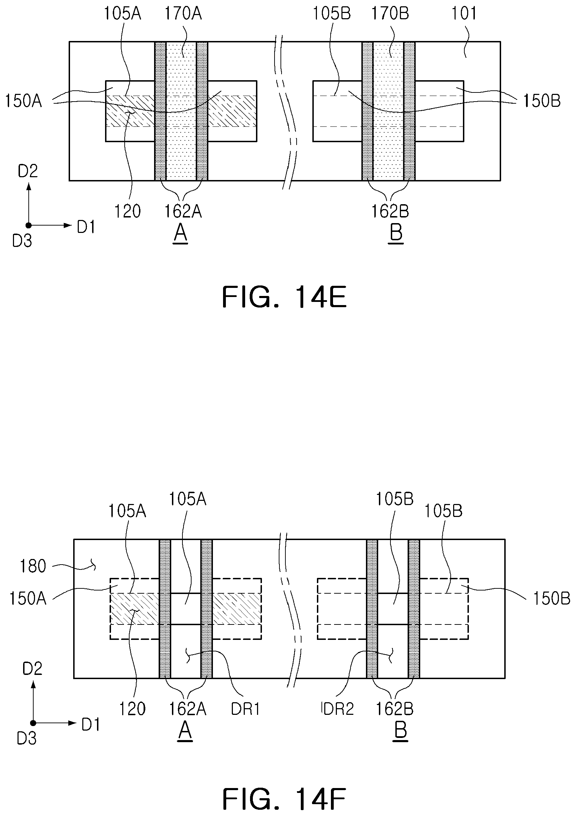

FIGS. 12A to 12F are cross-sectional diagrams illustrating operations of a method of manufacturing a semiconductor device (a fin isolation process) according to an example embodiment. FIGS. 14C, 14D, and 14E are plan diagrams illustrating the semiconductor device embodiments in FIGS. 12A, 12C, and 12F, respectively.

Referring to FIGS. 12A and 14C, by partially etching the substrate 101 obtained in the process in FIG. 11D, a first active fin 105A and a second active fin 105B extending in the first direction (e.g., D1) may be formed in the first region A and the second region B of the substrate 101, respectively.

The etching process for forming the fins may include an anisotropic etching process using a mask. For example, as the anisotropic etching process, a double patterning technology (DPT) or a quadraple patterning technology (QPT) may be used. The first and second active fins 105A and 105B may be etched more deeply than the first and second semiconductor layers 101P and 101U and may extend to a portion of regions of the semiconductor substrate 101' disposed below the sacrificial pattern 131.

As illustrated in FIG. 12A, the first active fin 105A may have a first fin portion 105a and a second fin portion 105b disposed on the first fin portion 105a, the first fin portion 105a and the second fin portion 105b may be isolated by the sacrificial pattern 131.

In the example embodiment, when the sacrificial pattern 131 is over-etched in the process of forming the first and second active fins 105A and 105B, the sacrificial pattern 131 may have a recessed side surface CS, inwardly recessed farther than the side surface of the first active fin 105A. Because the sacrificial pattern 131 defines an isolation pattern 120 (in FIG. 12E) formed in a subsequent process, the isolation pattern may be smaller than the width of the adjacent first active fin 105A portion by the over-etching (see FIG. 5A). Different from the example embodiment, when the sacrificial pattern 131 is etched less, the sacrificial pattern 131 may have a structure protruding from the side surface of the first active fin 105A. Accordingly, the isolation pattern 120 may be larger than the width of the adjacent portion of the first active fin 105A (see FIG. 5B).

Referring to FIG. 12B, the device isolation layer 110 at least partially surrounding the first and second active fins 105A and 105B may be formed.

In the device isolation layer 110, an insulating material layer may be formed to at least partially cover the first and second active fins 105A and 105B, and a process of planarizing the insulating material layer may be performed preferentially. For example, the device isolation layer 110 may be EOS, USG, PSG, BSG, BPSG, FSG, SOG, TOSZ, or a combination thereof.

During the planarization process, a mask (not illustrated) for forming the fin may be removed. After the planarization process, the isolation layer 110 may be formed by etchbacking the insulating material layer, such that a portion of regions of the first and second active fins 105A and 105B are exposed. The region in which the first and second active fins 105A and 105B are exposed may be provided as a channel region. In the example embodiment, the sacrificial pattern 131 of the first active fin 105A may be exposed during the process of etching-back the device isolation layer 101.

Referring to FIGS. 12C and 14D, the first dummy gate structure 170A and the second dummy gate structure 170B may be formed to intersect the first active fin 105A and the second active fin 105B, respectively.

The first and second dummy gate structures 170A and 170B may include a dummy gate pattern 175 and a cap mask 176, respectively. The cap mask 176 may be a mask pattern used to form the dummy gate pattern in the previous process. For example, the dummy gate pattern 175 may include polysilicon, and the cap mask 176 may include silicon nitride.

Referring to FIG. 12D, the sacrificial pattern 131 may be removed from the first active fin 105A.

This process may be performed after forming the first and second dummy gate structures 170A and 170B (FIG. 12C) and before forming the first and second gate spacers 162A and 162B (FIG. 12E). By selectively removing the sacrificial pattern 131, the isolation space SR for the isolation pattern 120 may be formed between the first fin portion 105a and the second fin portion 105b.

Referring to FIG. 12E, the first and second gate spacers 162A and 162B may be formed, and the isolation pattern 120 may be formed in the isolation space SR.

In the example embodiment, the process of forming the isolation pattern 120 may be performed simultaneously with the process of forming the first and second gate spacers 162A and 162B.

A pair of first gate spacers 162A and a pair of second gate spacers 162B may be formed on both side surfaces of each of the first and second dummy gate structures 170A and 170B, and the isolation space SR may also be at least partially filled with the same material as that of the first and second gate spacers 162A and 162B, thereby forming the isolation pattern 120. For example, the first and second gate spacers 162A and 162B may include silicon nitride (SiNₓ), silicon oxynitride (SiOₓN_{y}), silicon carbonitride (SiCₓN_{y}), silicon oxycarbonitride (SiOₓC_{y}N_{z}), or a combination thereof.

Specifically, a spacer material layer for the first and second gate spacers 162A and 162B may be conformally formed on the upper surface of the substrate 101 to at least partially cover the first and second active fins 105A and 105B and the first and second dummy gate structures 170A and 170B. In the process of forming the spacer material layer, the isolation space SR of the first active fin 105A may also be at least partially filled. This charging process may be more easily performed because the width of the first active fin 105A is relatively narrow in the second direction (e.g., D2) (see FIG. 4A).

Thereafter, the spacer material layer may be selectively removed through anisotropic etching. That is, other than the portions disposed on side surfaces of each structure (e.g., the first and second active fins 105A and 105B and the first and second dummy gate structures 170A and 170B) and the isolation pattern 120 disposed in the isolation space SR, portions disposed on the upper surface of each structure may be removed, and accordingly, the first and second gate spacers 162A and 162B and the isolation pattern 120 may be included. Also, the isolation pattern 120 may have a sidewall extension extending to the side surface of the exposed portions of the first active fin 105A (that is, the portion not covered by the first dummy gate structure 170A), and a spacer material layer may also remain on side surfaces of exposed portions of the second active fin 105B (portions not covered by the second dummy gate structure 170B) (see FIGS. 4A and 4B).

Also, in the isolation pattern 120, a first portion 120a grown from the upper surface of the first fin portion 105a and a second portion 120b grown from the lower surface of the second fin portion 105b may be merged such that the boundary surface BL may be formed between the first portion 120a and the second portion 120b.

Referring to FIGS. 12F and 14E, first source/drain regions 150A may be formed in regions of the first active fin 105A on both sides of the first dummy gate structure 170A, and second source/drain regions 150B may be formed in regions of the second active fin 105B on both sides of the second dummy gate structure 170B.

The exposed portions of the first and second active fins 105A and 105B may be etched to be recessed, and the first and second source/drain regions 150A and 150B may be formed on the recessed upper surface of the first and second active fins 105A and 105B using selective epitaxial growth (SEG). As described above, the first and second source/drain regions 150A and 150B may be formed as different epitaxial layers to form different types of MOSFET devices.

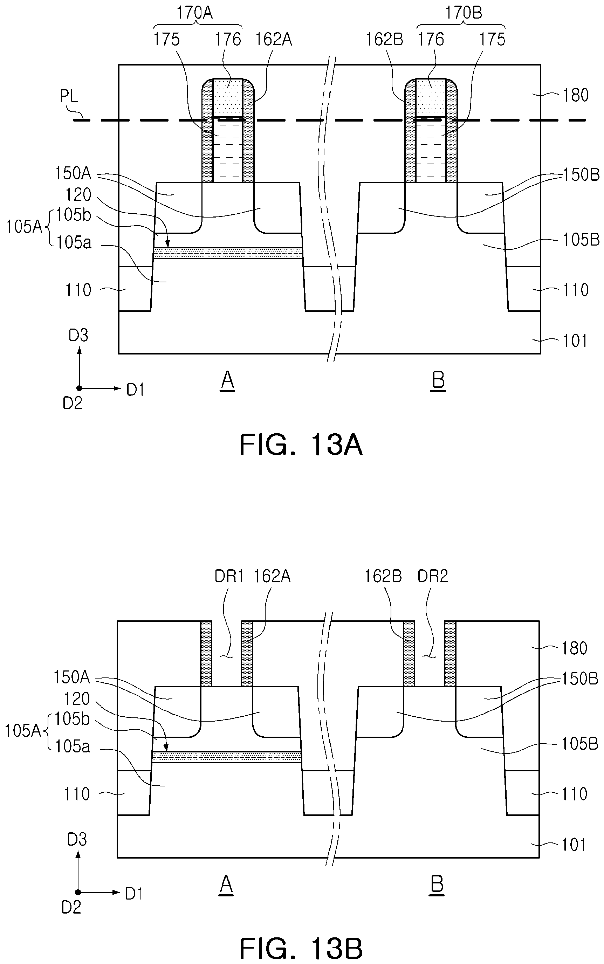

FIGS. 13A to 13D are cross-sectional diagrams illustrating operations of a method of manufacturing a semiconductor device (operations of forming a gate structure) according to an example embodiment. FIG. 14F is a plan diagram illustrating the semiconductor device embodiment in FIG. 13B.

Referring to FIG. 13A, an interlayer insulating layer 180 may be formed on the component obtained in the process in FIG. 12F.

An interlayer insulating layer may be formed on the isolation layer 110 to at least partially cover the first and second active fins 105A and 105B and the first and second dummy gate structures 170A and 170B. The interlayer insulating layer 180 may be disposed on the first and second source/drain regions 150A and 150B and may at least partially surround the dummy gate structures 170A and 170B. For example, the interlayer insulating layer 180 may include FOX, TOSZ, USG, BSG, PSG, BPSG, PETEOS, FSG, HDP, PEOX, FCVD oxide, or a combination thereof. The interlayer insulating layer 180 may be formed using a chemical vapor deposition (CVD) process, a flowable-CVD process, or a spin coating process.

Referring to FIGS. 13B and 14F, the dummy gate pattern 175 may be exposed, and the first gate opening DR1 and the second gate opening DR2 may be formed by removing the dummy gate pattern 175.

The exposing of the dummy gate pattern 175 may be performed by applying a planarization process to the interlayer insulating layer 180 up to the line PL in FIG. 13A. The first and second gate openings DR1 and DR2 may expose a portion of regions of the first and second active fins 105A and 105B. The first and second gate openings DR1 and DR2 may be provided as spaces for forming the first and second gate structures 160A and 160B, respectively.

Referring to FIG. 13C, first and second gate structures 160A and 160B may be formed in the first and second gate openings DR1 and DR2.

The first and second gate structures 160A and 160B may include first and second gate insulating layers 164A and 164B, first and second gate electrodes 165A and 165B, and first and second gate cap layers 166A and 166B, respectively. The first and second gate insulating layers 164A and 164B may be substantially conformally formed along internal side surfaces and lower surfaces of the first and second gate openings DR1 and DR2.

For example, the first and second gate insulating layers 164A and 164B may include oxide, nitride, or a high-k material, and may have a multilayer structure. A high-k material may be a dielectric material having a high dielectric constant relative to silicon dioxide. For instance, a high-k material may have a dielectric constant that is greater than that of silicon dioxide. Also, the first and second gate electrodes 165A and 165B may include doped polysilicon, metal, conductive metal nitride, conductive metal carbide, or a combination thereof. For example, the first and second gate electrodes 165A and 165B may be formed of Al, Cu, Ti, Ta, W, Mo, TaN, NiSi, CoSi, TiN, WN, TiAl, TiAlN, TaCN, TaC, TaSiN, or a combination thereof, but an example embodiment thereof is not limited thereto.

As described above, the first gate insulating layer 164A and/or the first gate electrode 165A may include a material different from that of the second gate insulating layer 164B and/or the second gate electrode 165B, or may include a different number of layers.

Referring to FIG. 13D, first and second contact structures 190A and 190B extending through the interlayer insulating layer 180 may be formed.

First and second contact holes connected to the first and second source/drain regions 120A and 120B, respectively, may be formed in the interlayer insulating layer 180, and first and second contact structures 190A and 190B may be formed in the first and second contact holes. The first and second contact structures 190A and 190B may be formed together through the same process.

The first and second contact structures 190A and 190B may include a conductive barrier 192 preventing diffusion of the contact plug 195 material. The conductive barrier 192 may be conformally formed using an ALD or CVD process. For example, the conductive barrier 192 may include TiN, TaN, AlN, WN, and a combination thereof. Also, the contact plug 195 may include tungsten (W), cobalt (Co), titanium (Ti), an alloy thereof, or a combination thereof.

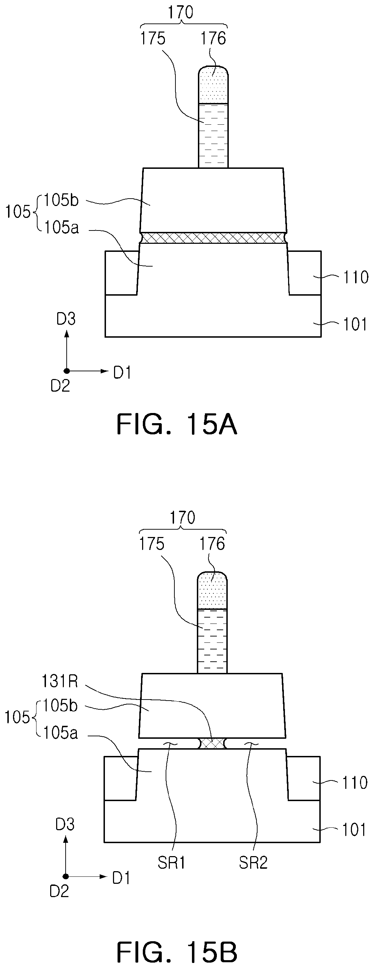

FIGS. 15A to 15F are cross-sectional diagrams illustrating operations of a method of manufacturing a semiconductor device according to an example embodiment. The manufacturing process relates to a method of manufacturing the GAA FinFET structure, similar to the semiconductor device 100D illustrated in FIGS. 8 and 9A to 9C.

Referring to FIG. 15A, the active fin 105 may include a first fin portion and a second fin portion, and may have a sacrificial pattern between the first and second fin portions. A dummy gate structure 170 may be formed to intersect the active fin 105. The dummy gate structure 170 may include a dummy gate pattern 175 and a cap mask 176, which may be components corresponding to the device region on the left in FIG. 12C.

Referring to FIG. 15B, the sacrificial pattern 131 may be removed from the first active fin 105A, and the sacrificial pattern portion 131R disposed in a region overlapping the dummy gate structure 170 may remain.

In this operation, different from the aforementioned example embodiment, the sacrificial pattern 131 may be partially removed. Because the residual sacrificial pattern portion 131R overlaps the dummy gate structure 170, the sacrificial pattern portion 131R may remain due to an etching delay different from other portions of the sacrificial pattern 131. First and second isolation spaces SR1 and SR2 may be present on both sides of the residual sacrificial pattern portion 131R.

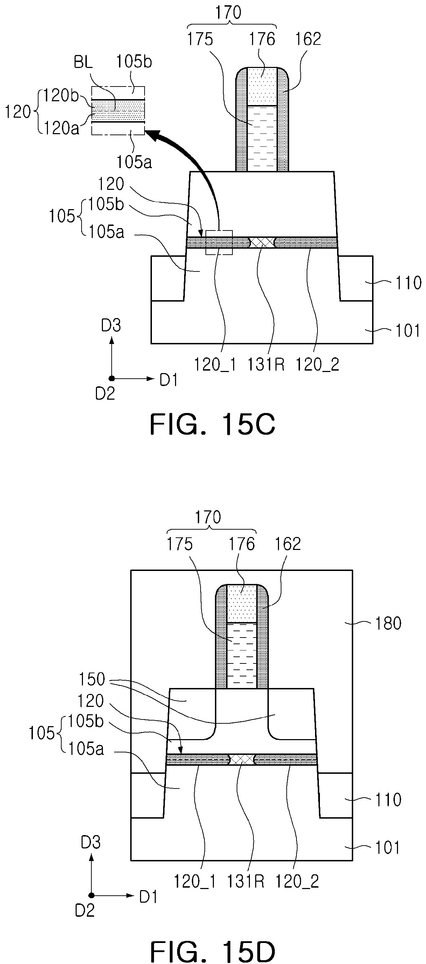

Referring to FIG. 15C, gate spacers 162 may be formed on both sides of the dummy gate structure 170, and first and second isolation patterns 120_1 and 120_2 may be formed in the first and second isolation spaces SR1 and SR2.

In the example embodiment, the process of forming the first and second isolation patterns 120_1 and 120_2 may be performed simultaneously with the process of forming the gate spacer 162.

A pair of gate spacers 162 may be formed on both side surfaces of the dummy gate structure 170, and the first and second isolation spaces SR1 and SR2 may be at least partially filled with the same material as that of the gate spacers 162A and 162B and the first and second isolation patterns 120_1 and 120_2 may be formed.

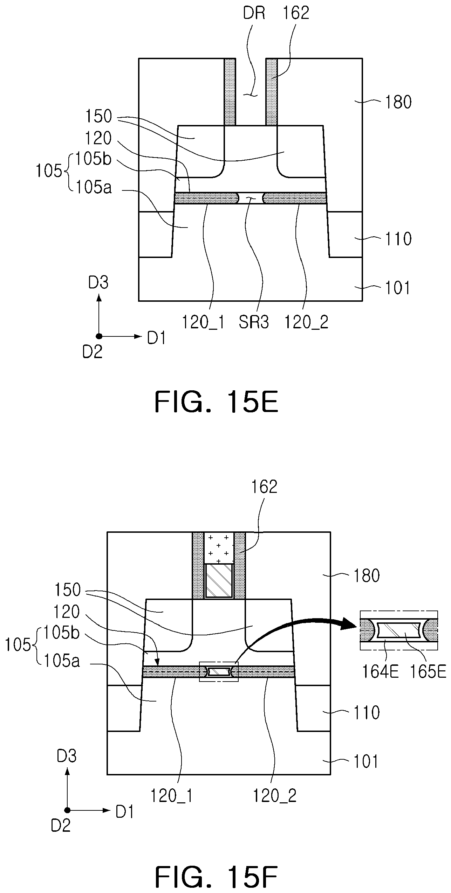

Referring to FIG. 15D, an interlayer insulating layer 180 may be formed on the device isolation layer 110 to at least partially cover the active fin 105 and the dummy gate structure 170, and referring to FIG. 15E, the gate pattern 175 may be exposed through a polishing process, and the dummy gate pattern 175 may be removed, thereby forming a gate opening DR. Thereafter, an etching process may be additionally performed to remove the residual sacrificial pattern 131R. As the residual sacrificial pattern 131R is removed, a third isolation space SR may be formed between the first and second fin portions 105A and 105B. This removal process may include an etching process performed two times. For example, the process of removing the dummy gate pattern 175 may be performed by a process of etching polysilicon, and the process of removing the residual sacrificial pattern 131R may be performed by a process of etching silicon germanium.

Referring to FIG. 15F, the gate structure 160 may be formed in the gate opening DR and the third isolation space SR3.

The gate insulating layer 164 may be conformally formed along an internal side surface and a lower surface of the gate opening DR and an internal surface of the third isolation space SR3, and the gate electrode 165 may be formed in the remaining space. Additionally, a gate capping layer 166 may be formed in the remaining space of the gate opening DR.

The gate electrode 165 may have an extension electrode portion 165E at least partially surrounding the second fin portion 105b in the second direction (e.g., D2), and the gate insulating layer 164 may have an extension portion 164E at least partially surrounding the extension electrode portion 165E in the first direction (e.g., D1). As described above, the semiconductor device according to the example embodiment may be implemented in a GAA structure.

FIG. 16 is a plan diagram illustrating a semiconductor device according to an example embodiment. FIG. 17A to 17C are cross-sectional diagrams illustrating the semiconductor device embodiments illustrated in FIG. 16 taken along lines I-I', II1-II1', and II2-II2', respectively.

Referring to FIGS. 16 and 17A to 17C, a semiconductor device 100E according to the example embodiment may be similar to the example embodiment illustrated in FIGS. 1A-4B other than the configuration in which a plurality of active fins 105 may be provided and each of the source/drain regions 150 may be formed throughout the plurality of active fins 105. Also, the components in the example embodiment may be understood with reference to the descriptions of the same or similar components in the example embodiments illustrated in FIGS. 1A to 4B unless otherwise indicated.

The semiconductor device 100E according to the example embodiment may include a plurality of active fins 105 (e.g., three active fins 105), and each of the source/drain regions 150 may be formed throughout the three active fins 105. Each of the plurality of active fins 105 may include an isolation pattern 120 between the first fin portion 105A and the second fin portion 105B, and the isolation pattern 120 may be disposed on the same level in the D3 direction in the different active fins 105. Also, the isolation patterns 120 may have the same thickness.

In the example embodiment, the number of the active fins 105 connected to each of the source/drain regions 150 may be three, but a different number of active fins may be arranged as above.

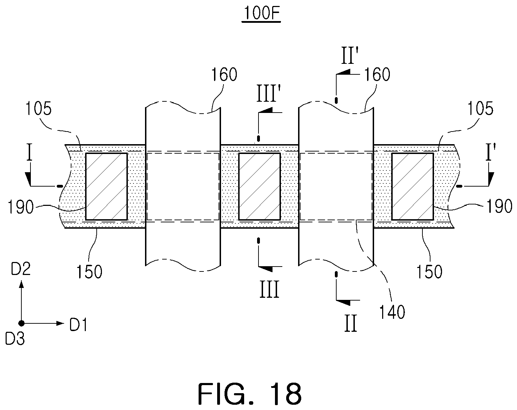

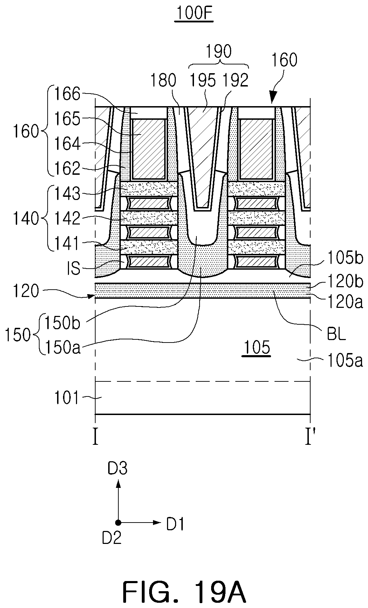

FIG. 18 is a plan diagram illustrating a semiconductor device according to an example embodiment. FIGS. 19A to 19C are cross-sectional diagrams illustrating the semiconductor device embodiments illustrated in FIG. 18 taken along lines I-I', II1-II1', and II2-II2', respectively.

Referring to FIGS. 18 and 19A to 19C, a semiconductor device 100F according to the example embodiment may be similar to the example embodiment illustrated in FIGS. 1 to 4B other than the configuration in which the semiconductor device 100F is implemented in a multi-channel structure 140 using a plurality of channel layers 141, 142, and 143. Also, the components in the example embodiment may be understood with reference to the descriptions of the same or similar components in the example embodiments illustrated in FIGS. 1A to 4B unless otherwise indicated.

Three channel layers 141, 142, and 143 spaced apart from each other in a direction (e.g., D3) perpendicular to the upper surface of the substrate 101 on the active fin (herein, referred to as "active pattern 105") extending in the first direction (e.g., D1), and a gate electrode 165 surrounding the three channel layers 141, 142, and 143 and extending in a second direction (e.g., D2) intersecting the first direction (e.g., D1) may be included. As described above, the gate electrode 165 used in the example embodiment may be formed to be interposed between the gate spacers 162 and also between the channel layers 141, 142, and 143.

The semiconductor device 100F may include a source/drain region 150 disposed on the active pattern 150 disposed on both sides of the gate electrode 165, and connected to the channel layers 141, 142, and 143. In the example embodiment, the source/drain regions 150 may be disposed on the active pattern 105 disposed on both sides of the gate electrode 165, and may be connected to both sides of the channel layers 141, 142, and 143 in the first direction (e.g., D1). In the example embodiment, the number of the channel layers 141, 142, and 143 may be three, but the number of the channel layers is not limited to any particular example. The channel layers 141, 142, and 143 may include semiconductor patterns. For example, the semiconductor patterns may include silicon (Si), silicon germanium (SiGe), and/or germanium (Ge).

The source/drain region 150 may include an epitaxial layer formed using the plurality of channel layers 141, 142, and 143 and the active pattern 105 as a seed. The source/drain region 150 may include silicon germanium (SiGe), silicon (Si), and/or silicon carbide (SiC).

Internal spacers IS provided between each of the source/drain regions 150 and the gate electrode 165 may be included. The internal spacers IS may be provided on one side of the gate electrode 165. The internal spacers IS and the channel layers 141, 142, and 143 may be alternately disposed in the direction (e.g., D3) perpendicular to the upper surface of the substrate 101. Each of the source/drain regions 150 may be in contact with the channel layers 141, 142, and 143, and may be spaced apart from the gate electrode 165 with the internal spacers IS interposed therebetween. The gate insulating layer 164 may be interposed between the gate electrode 165 and each of the channel layers 141, 142, and 143, and may extend to a region between the gate electrode 165 and each of the internal spacers IS.

As illustrated in FIGS. 19A to 19C, the active pattern 105 may be divided into a first fin portion 105a and a second fin portion 105b disposed on the first fin portion 105a, and the isolation pattern 120 may be disposed between the first fin portion 105a and the second fin portion 105b. The isolation pattern 120 may be formed together with the gate spacer 162 of the gate structure 160.

Similar to the aforementioned example embodiment, the isolation pattern 120 used in the example embodiment may include a first portion 120a grown from the upper surface of the first fin portion 105a and a second portion 120b grown from the lower surface of the second fin portion 105b, and a boundary surface BL may be formed between the first portion 120a and the second portion 120b. The boundary surface BL may be formed by merging the first portion 120a and the second portion 120b.

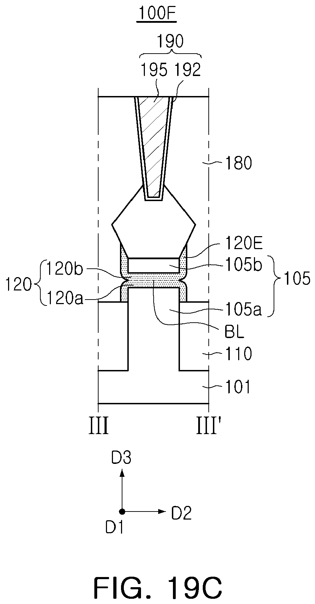

As illustrated in FIG. 19C, the isolation pattern 120 may have a sidewall extension portion 120E extending to the sidewall of the active pattern 150, that is, sidewalls of the first fin portion 150a and the second fin portion 150b.

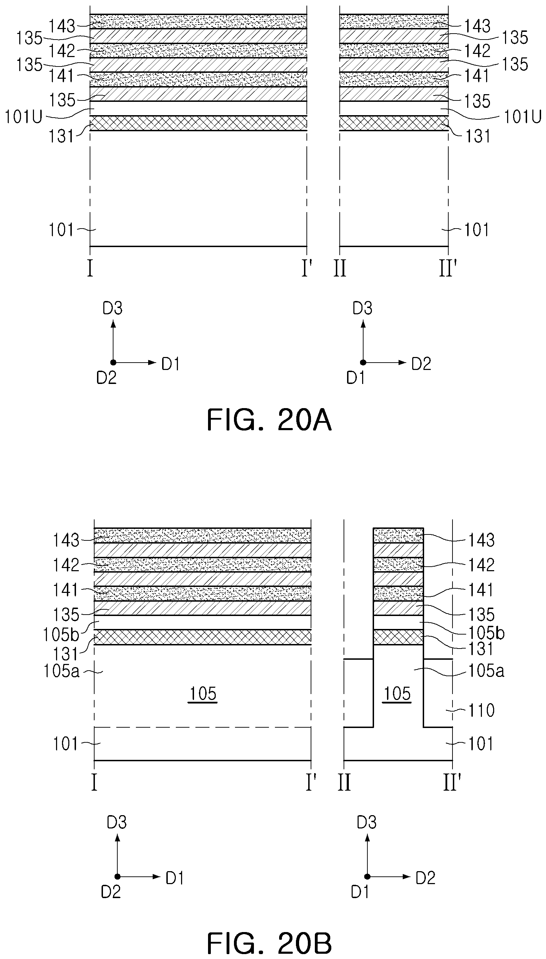

FIGS. 20A to 20H are cross-sectional diagrams illustrating operations of a method of manufacturing a semiconductor device according to an example embodiment.

Referring to FIG. 20A, second sacrificial layers 135 and channel layers 141, 142, and 143 may be alternately stacked on a substrate 101. Also, the substrate 101 may further include an embedded first sacrificial layer 131. That is, the first sacrificial layer 131 at least partially covered with the upper semiconductor layer 101U may be included on the upper surface of the substrate 101.

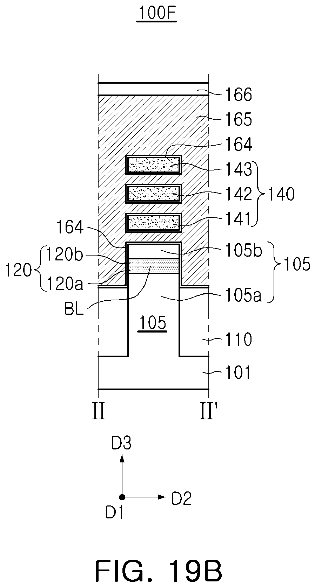

The second sacrificial layers 135 may be sacrificial layers for forming a multi-channel structure, and may provide a space for the gate insulating layer 162 and the gate electrode 165 illustrated in FIGS. 19A and 19B. The second sacrificial layers 135 may be formed of a material having etch selectivity with respect to the channel layers 141, 142, and 143. The channel layers 141, 142, and 143 may include a material different from that of the second sacrificial layers 120. The second sacrificial layers 135 and the channel layers 141, 142, and 143 may include, for example, a semiconductor material including silicon (Si), silicon germanium (SiGe), and/or germanium (Ge), and may include different materials. The channel layers 141, 142, and 143 may include impurities, but an example embodiment thereof is not limited thereto.

For example, the second sacrificial layers 135 may include silicon germanium (Si₁₋ₓ₂Geₓ₂), and the channel layers 141, 142, and 143 may include silicon (Si).

The first sacrificial layer 132 may be used as a sacrificial layer for the isolation pattern. For example, the substrate 101 may be a silicon substrate, and the first sacrificial layer 131 may be Si₁₋ₓ₁Geₓ₁. Because the first sacrificial layer 131 requires etching selectivity with respect to the second sacrificial layers 135, the first germanium content x1 of the first sacrificial layer 131 may be greater than the second germanium content x2 of the second sacrificial layers 135. In example embodiments, the first germanium content x1 may be 0.3 or more greater than the second germanium content x2.

Thereafter, referring to FIG. 20B, the active structures may be formed by removing a portion of the substrate 101 in which the stack structure of the second sacrificial layers 135 and the channel layers 141, 142, and 143 and the first sacrificial layer 131 are embedded.

The active structure may include second sacrificial layers 135 and channel layers 141, 142, and 143 alternately stacked on the active pattern 105 extending in the first direction (e.g., D1). The active pattern 105 may include first and second fin portions 105a and 105b and a first sacrificial layer 131 disposed between the first and second fin portions 105a and 105b. The device isolation layer 110 may be formed in a region from which a portion of the substrate 101 is removed by at least partially filling an insulating material and recessing the material to allow the active region 105 to protrude. The upper surface of the device isolation layer 110 may be formed on a level lower than a level of the first sacrificial layer 131 embedded in the active pattern 105 in the D3 direction.

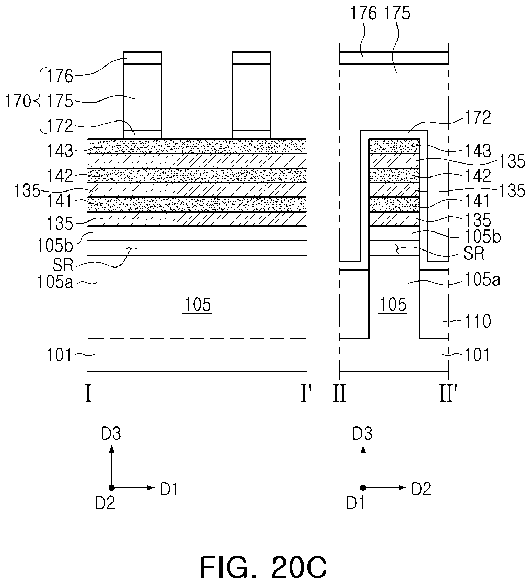

Thereafter, referring to FIG. 20C, dummy gate structures 170 intersecting the active structures may be formed, and an isolation space SR may be prepared by removing the first sacrificial layer 131.

The dummy gate structures 170 may be sacrificial structures for a space on the channel structure 140 in which the gate insulating layer 164 and the gate electrode 165 are disposed through a subsequent process. The dummy gate structures 170 may have a line shape extending in a second direction (e.g., D2 direction) by intersecting the active structures, and may be arranged to be spaced apart from each other in a first direction (e.g., D1 direction). The dummy gate structures 170 may include first and second sacrificial gate patterns 172 and 175 and a cap mask 176 stacked in order.

In example embodiments, the first sacrificial gate pattern 172 may include silicon oxide, and the second sacrificial gate pattern 175 may include polysilicon. The cap mask 176 may include silicon oxide and/or silicon nitride.

After forming the dummy gate structures 170 and before forming the gate spacers 162, the first sacrificial layer 131 may be selectively removed. Through this, an isolation space SR for the isolation pattern 120 may be formed between the first fin portion 105a and the second fin portion 105b.

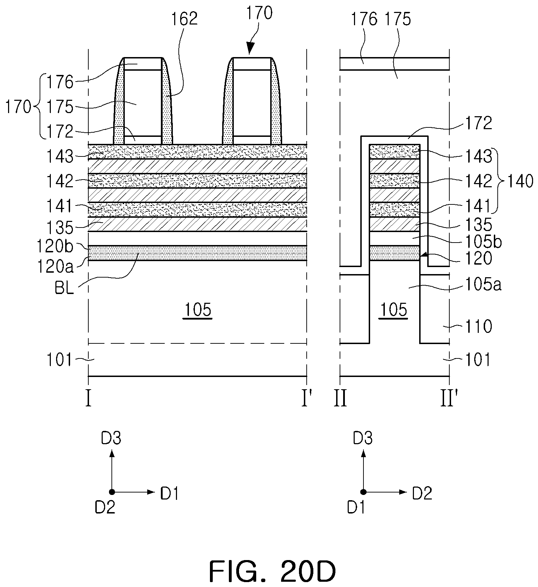

Thereafter, referring to FIG. 20D, gate spacers 162 may be formed on both side surfaces of the dummy gate structures 170, respectively, on the active structures, and the isolation pattern 120 may be formed in the isolation space SR.

In the example embodiment, the process of forming the isolation pattern 120 may be performed simultaneously with the process of forming the gate spacers 162.

A pair of gate spacers 162 may be formed on both side surfaces of each of the dummy gate structures 170, respectively, and the isolation space SR may also be at least partially filled with the same material as that of the gate spacers 162, thereby forming an isolation pattern 120.

Specifically, the spacer material layer for the gate spacers 162 may be conformally formed on the upper surface of the substrate 101 to at least partially cover the active structure and the dummy gate structures 170. In the process of forming the spacer material layer, the isolation space SR of the active pattern 105 may also be at least partially filled. Thereafter, by selectively removing the spacer material layer through anisotropic etching, gate spacers 162 and an isolation pattern 120 may be formed as illustrated in FIG. 20D. Also, because the isolation pattern 120 is formed by merging the first portion 120a grown from the upper surface of the first fin portion 105a and the second portion 120b grown from the lower surface of the second fin portion 105b, a boundary surface BL may be formed between the first portion 120a and the second portion 120b.

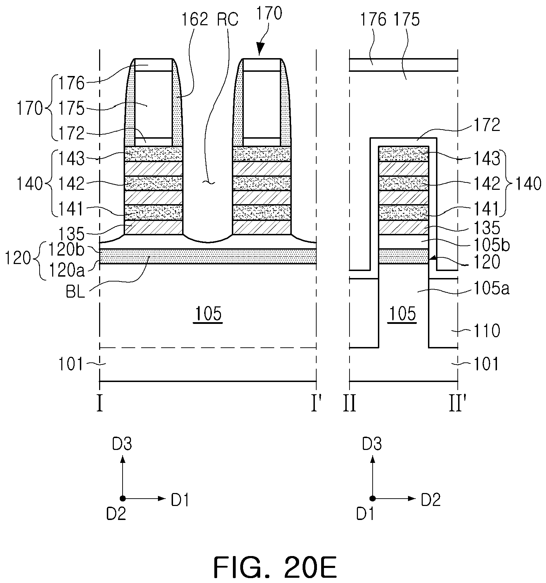

Thereafter, referring to FIG. 20E, the recess RC may be formed by removing the second sacrificial layers 135 and the channel layers 141, 142, and 143 exposed on both sides of the dummy gate structures 170. Through this process, the channel structures 140 may be formed.

The exposed sacrificial layers 120 and the channel layers 141, 142, and 143 may be removed using the dummy gate structures 170 and the gate spacers 162 as masks. After the recess RC is formed through the removing process, the channel layers 141, 142, and 143 may have a limited length in the first direction (e.g., D1). The second sacrificial layers 135 and the channel structure 140 may be partially removed from side surfaces below the dummy gate structures 170, such that both side surfaces of the dummy gate structures 170 in the first direction (e.g., D1) may be disposed below the dummy gate structures 170 and the gate spacer 162.

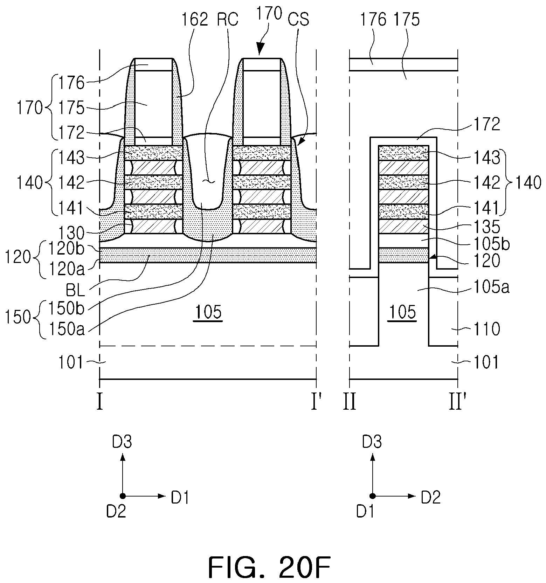

Thereafter, referring to FIG. 20F, by partially removing the exposed second sacrificial layers 135 from the side surface, the internal spacer layers 130 may be formed in the region from which the sacrificial layers 120 are removed. Thereafter, the source/drain regions 150 may be formed in the recesses RC disposed on both sides of the dummy gate structures 170.

The second sacrificial layers 135 may be selectively etched with respect to the channel structures 140 by, for example, a wet etching process, and may be removed to a predetermined depth from the side surface in the first direction (e.g., D1). The second sacrificial layers 135 may provide spaces recessed inwardly by the etching the side surfaces as described above. The internal spacer layers 130 may be formed in a space from which the second sacrificial layers 135 are partially removed. For example, the internal spacer layers 130 may include at least one of SiN, SiCN, SiOCN, SiBCN, and SiBN.

In the example embodiment, the source/drain regions 150 may be obtained by sequentially forming a first epitaxial layer 150a and a second epitaxial layer 150b having different compositions (e.g., Ge content) or different impurity concentrations.

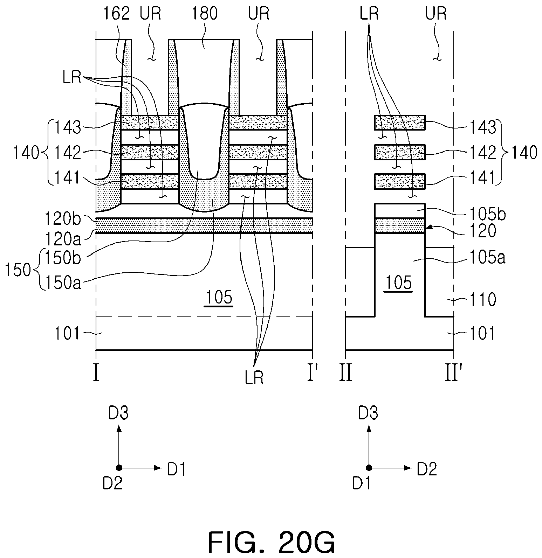

Thereafter, referring to FIG. 20G, the interlayer insulating layer 180 may be formed between the dummy gate structures 170, and the second sacrificial layers 135 and the dummy gate structures 170 may be removed.

The interlayer insulating layer 180 may be formed by forming an insulating layer at least partially covering the dummy gate structures 170 and the source/drain regions 150 and performing a planarization process. The second sacrificial layers 135 and the dummy gate structure 170 may be selectively removed with respect to the gate spacer 162, the interlayer insulating layer 180, and the channel structure 140. First, upper gap regions UR may be formed by removing the dummy gate structures 170, and lower gap regions LR may be formed by removing the second sacrificial layers 135 exposed through the upper gap regions UR. For example, when the second sacrificial layers 135 include silicon germanium (Si₁₋ₓ₂Geₓ₂) and the channel structure 140 includes silicon (Si), the sacrificial layers 120 may be selectively removed by performing a wet etching process using peracetic acid as an etchant. During the removing process, the source/drain regions 150 may be protected by the interlayer insulating layer 180 and the internal spacers IS.

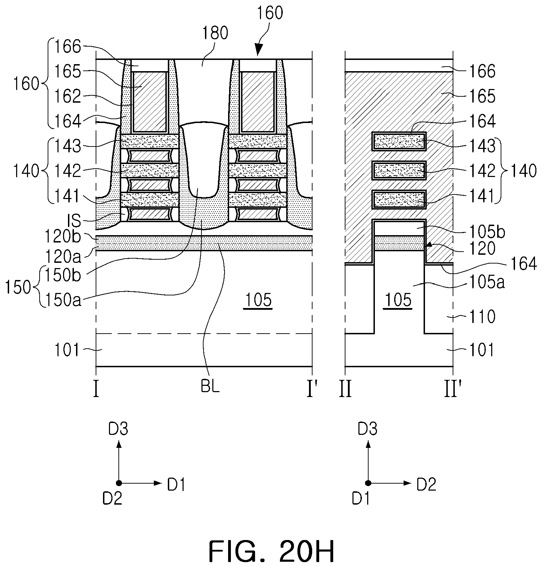

Thereafter, referring to FIG. 20H, gate structures 160 may be formed in the upper gap regions UR and the lower gap regions LR.

The gate insulating layers 164 may be formed to conformally at least partially cover internal surfaces of the upper gap regions UR and the lower gap regions LR. The upper gap regions UR and the lower gap regions LR may be formed to be completely embedded, and the gate electrodes 165 may be removed from the upper portion to a predetermined depth in the upper gap regions UR. A gate cap layer 166 may be formed in a region of the upper gap regions UR from which the gate electrodes 165 are removed. Accordingly, the gate structures 160 including the gate insulating layer 164, the gate electrode 165, the gate spacer 162, and the gate cap layer 166 may be formed.

Thereafter, by forming a contact structure 190 connected to the source/drain region 150 that extends through the interlayer insulating layer 180, the semiconductor device 100F illustrated in FIGS. 18 and 19A to 19C may be manufactured.

According to the aforementioned example embodiments, without using a silicon on insulator (SOI) substrate, by removing the embedded sacrificial pattern after forming the active fin and at least partially filling the removed space with the same material when forming the gate spacer, a semiconductor device, such as a desired SOI FinFET structure may be manufactured.

As such, the semiconductor device (e.g., a single gate (SG) transistor, or an N-MOSFET), such as an SOI finFET structure having improved short-channel effect properties, may be manufactured through a more simplified process, and may be implemented together with a semiconductor device (e.g., an enhanced gate (EG) transistor, or P-MOSFET), such as a bulk FinFET on a substrate.

While the example embodiments have been illustrated and described above, it will be configured as apparent to those skilled in the art that modifications and variations could be made without departing from the scope of the present disclosure as defined by the appended claims.

## Claims

1. A semiconductor device, comprising:
an active fin extending in a first direction on an upper surface of a substrate, the active fin comprising a first fin portion and a second fin portion on the first fin portion;
an isolation pattern between the first fin portion and the second fin portion;
a gate structure intersecting the active fin and extending in a second direction intersecting the first direction; and
source/drain regions in regions of the second fin portion on both sides of the gate structure, respectively;
wherein the gate structure includes a gate electrode intersecting a region of the active fin and extending in the second direction, a pair of gate spacers extending in the second direction along both side surfaces of the gate electrode in the first direction, the pair of gate spacers and the isolation pattern comprising a same material, and a gate insulating layer between the gate electrode and the active fin.

2. The semiconductor device of claim 1, wherein the isolation pattern includes a first portion grown from an upper surface of the first fin portion, and a second portion having a boundary surface with the first portion and grown from a lower surface of the second fin portion.

3. The semiconductor device of claim 2, wherein each of the pair of gate spacers includes a first spacer film and a second spacer film on both of the side surfaces of the gate electrode, respectively.

4. The semiconductor device of claim 3,
wherein each of the first portion and the second portion of the isolation pattern includes a first insulating film and a second insulating film symmetrically arranged with respect to the boundary surface, and
wherein the first insulating film and the first spacer film comprise a same material, and the second insulating film and the second spacer film comprise a same material.

5. The semiconductor device of claim 3, wherein each of the first portion and the second portion of the isolation pattern is formed of a same insulating material as that of the first spacer film.

6. The semiconductor device of any preceding claim, wherein the isolation pattern has a width smaller than a width of adj acent portions of the first and second fin portions in a cross-section of a portion of the active fin, taken in the second direction, in which the gate structure is disposed.

7. The semiconductor device of any of claims 1-5, wherein the isolation pattern has a width greater than a width of adjacent portions of the first and second fin portions in a cross-section of a portion of the active fin, taken in the second direction, in which the gate structure is disposed.

8. The semiconductor device of any preceding claim,
wherein the gate electrode has an extension electrode portion passing through a region between the first fin portion and the second fin portion to at least partially surround the second fin portion in the second direction, and
wherein the isolation pattern is divided into a first pattern and a second pattern by the extension electrode portion.

9. The semiconductor device of claim 8, wherein the gate insulating layer has an extended portion at least partially surrounding the extension electrode portion in the first direction.

10. The semiconductor device of any preceding claim,
wherein the active fin includes a plurality of active fins, and the source/drain region is disposed throughout the plurality of active fins, and
wherein the isolation patterns of the plurality of active fins are on a same level relative to the upper surface of the substrate being a base reference level.

11. The semiconductor device of any preceding claim, wherein the isolation pattern has a sidewall extension portion extending to a sidewall of the active fin in a cross-section of a portion of the active fin, taken in the second direction, in which the source/drain regions are disposed.

12. The semiconductor device of any preceding claim, further comprising:
a plurality of channel layers spaced apart from each other in a direction perpendicular to an upper surface of the substrate on the active fin and extending in the first direction,
wherein the source/drain regions are connected to the plurality of channel layers, respectively, and
wherein the gate electrode at least partially surrounds the plurality of channel layers and extends in the second direction, and the gate insulating layer is between the plurality of channel layers and the gate electrode and between the active fin and the gate electrode.

13. A method of manufacturing a semiconductor device, the method comprising:
providing a semiconductor substrate having an upper surface divided into a first region and a second region;
forming a sacrificial pattern in the first region of the semiconductor substrate;
growing a semiconductor layer on the semiconductor substrate to at least partially cover the sacrificial pattern;
forming a first active fin and a second active fin extending in a first direction on the first and second regions of the semiconductor substrate by etching to a portion of regions of the semiconductor layer and the semiconductor substrate, where the first active fin has a first fin portion and a second fin portion on the first fin portion, and the first fin portion and the second fin portion are isolated from each other by the sacrificial pattern;
forming a first dummy gate structure and a second dummy gate structure that intersect the first active fin and the second active fin, respectively;
removing the sacrificial pattern from the first active fin to form an isolation space between the first fin portion and the second fin portion;
forming a pair of first gate spacers and a pair of second gate spacers on both side surfaces of the first dummy gate structure and the second dummy gate structure, respectively, and forming an isolation pattern by filling the isolation space with a same material as a material of the first and second gate spacers;
forming a first source/drain region and a second source/drain region in regions of the first active fin on both sides of the first dummy gate structure and regions of the second active fin on both sides of the second dummy gate structure, respectively;
removing the first dummy gate structure and the second dummy gate structure to form a first gate space and a second gate space; and
forming a first gate structure and a second gate structure in the first gate space and the second gate space, respectively,
wherein the forming of the isolation pattern is performed simultaneously with the forming the first and second gate spacers.

14. The method of claim 13, wherein the growing the semiconductor layer includes:
forming a mask on the sacrificial pattern;
growing a first semiconductor layer in the second region of the substrate using the mask to have an upper surface having a same level as a level of an upper surface of the sacrificial pattern relative to the upper surface of the substrate being a base reference level; and
re-growing a second semiconductor layer on the sacrificial pattern and the first semiconductor layer.

15. The method of claim 13 or claim 14,
wherein the removing the sacrificial pattern from the first active fin includes removing the sacrificial pattern from the first active fin, such that the sacrificial pattern portion in a region overlapping the first dummy gate structure remains,
wherein the isolation space is divided into a first isolation space and a second isolation space in the first direction by the remaining sacrificial pattern portion, and
wherein the forming the isolation pattern includes forming first and second isolation patterns in the first and second isolation spaces, respectively.
